(19) Europäisches Patentamt
European Patent Office
Office européen des brevets

(11) **EP 2 515 432 B1**

(12) **FASCICULE DE BREVET EUROPEEN**

(45) Date de publication et mention
de la délivrance du brevet:
**05.06.2019 Bulletin 2019/23**

(21) Numéro de dépôt: **12163831.6**

(22) Date de dépôt: **12.04.2012**

(51) Int Cl.:
***H03B 15/00*** *(2006.01)*

(54) **Synthétiseur d'un signal oscillant**

Frequenzgenerator eines oszillierenden Signals

Oscillating signal synthesiser

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2011 FR 1153425**

(43) Date de publication de la demande:
**24.10.2012 Bulletin 2012/43**

(73) Titulaire: **Commissariat à l'Énergie Atomique et aux Énergies Alternatives**
**75015 Paris (FR)**

(72) Inventeurs:
 • **Michel, Jean-Philippe**
 **38600 Fontaine (FR)**
 • **Quinsat, Michael**
 **38000 Grenoble (FR)**

(74) Mandataire: **Colombo, Michel et al**
**Brevinnov**
**310 avenue Berthelot**
**69008 Lyon (FR)**

(56) Documents cités:
**US-A1- 2011 051 481      US-A1- 2014 043 074**

• **SERGEI URAZHDIN ET AL: "Fractional Synchronization of Spin-Torque Nano-Oscillators", PHYSICAL REVIEW LETTERS, vol. 105, no. 10, 1 août 2010 (2010-08-01) , XP055014753, ISSN: 0031-9007, DOI: 10.1103/PhysRevLett.105.104101**
• **B. GEORGES ET AL: "Coupling Efficiency for Phase Locking of a Spin Transfer Nano-Oscillator to a Microwave Current", PHYSICAL REVIEW LETTERS, vol. 101, no. 1, 1 juillet 2008 (2008-07-01), XP055014786, ISSN: 0031-9007, DOI: 10.1103/PhysRevLett.101.017201**
• **W. RIPPARD ET AL: "Injection Locking and Phase Control of Spin Transfer Nano-oscillators", PHYSICAL REVIEW LETTERS, vol. 95, no. 6, 1 août 2005 (2005-08-01), XP055014766, ISSN: 0031-9007, DOI: 10.1103/PhysRevLett.95.067203**
• **ZARUDNIEV M ET AL: "Spintorque Oscillator Characteristics in Coupled Networks", HARDWARE AND SOFTWARE IMPLEMENTATION AND CONTROL OF DISTRIBUTED MEMS (DMEMS), 2010 FIRST WORKSHOP ON, IEEE, PISCATAWAY, NJ, USA, 28 juin 2010 (2010-06-28), pages 20-23, XP031711118, ISBN: 978-1-4244-7222-2**

EP 2 515 432 B1

Printed by Jouve, 75001 PARIS (FR)

**Description**

L'invention concerne un synthétiseur d'un signal oscillant et un procédé de synthèse d'un signal oscillant $s_t(t)$ à une fréquence $f_t$.

Les synthétiseurs de fréquence connus comportent généralement :

- un premier étage de synthèse de fréquence apte à générer sur une borne de sortie un signal oscillant $s_0(t)$ à une fréquence $f_0$, ce premier étage comprenant une boucle à verrouillage de phase,
- une borne de restitution sur laquelle est restitué le signal oscillant $s_t(t)$ à la fréquence $f_t$.

L'inconvénient des synthétiseurs connus, tels que ceux comportant des oscillateurs contrôlés en tension (VCO) asservis dans une boucle à verrouillage de phase, est que leur encombrement est souvent important.

Par ailleurs, les systèmes de télécommunications reposent souvent sur l'utilisation de différentes fréquences porteuses modulées par des informations à transmettre. Chaque système standardisé utilise sa ou ses propres fréquences porteuses. Un appareil de télécommunication susceptible d'être utilisé dans différents systèmes de télécommunication doit donc être capable de générer des signaux oscillants à différentes fréquences porteuses. Or un même synthétiseur ayant un faible encombrement ne peut pas produire les différentes fréquences porteuses requises pour fonctionner dans les différents systèmes de télécommunications. On dit qu'un tel synthétiseur a une agilité spectrale limitée puisqu'il ne peut pas produire un signal oscillant à des fréquences s'étendant sur une plage de plusieurs gigahertz. Il faut donc utiliser plusieurs synthétiseurs distincts dans le même appareil de télécommunication. Chaque synthétiseur distinct est configuré pour générer des fréquences sur une plage prédéterminée différente de celles générées par les autres synthétiseurs.

De l'état de la technique est également connu de :

- Sergei Urazhdin et al, « Fractionnai Synchronization of Spin-Torque Nono-Oscillator », Physical Review Letters, vol. 105, n°10, 1/8/2010,
- B. Georges et Al, « Coupling efficiency for phase locking of a spin transfer nano-Oscillatorto a microwave current », Physical Review letters, vol. 101, n°1, 1/7/2008,
- W. Rippard et Al, « Injection locking and phase control of spin transfer Nano-oscillators », Physical Review letters, vol. 95, n°6, 1/8/2005,
- Zarudniev M et Al, « Spintorque Oscillator Characteristics in coupled Networks », Hardware and software implementation and control of distributed mems (DMEMS), 2010, First Workshop on, IEEE, Piscataway, NJ, USA, 28/6/2010, pages 20-23,
- US2011/051481A1.

L'invention vise à remédier à au moins l'un de ces inconvénients.

Elle a donc pour objet un synthétiseur d'un signal oscillant $s_t(t)$ conforme à la revendication 1.

Ce synthétiseur présente un encombrement réduit par rapport au synthétiseur connu car il utilise un dispositif magnétorésistif pour générer le signal $s_t(t)$ oscillant à la fréquence $f_t$. En effet, de tels dispositifs magnétorésistifs présentent des dimensions bien inférieures au micromètre. Plus précisément, le dispositif magnétorésistif permet de décroître l'encombrement du synthétiseur par rapport à un synthétiseur connu équipé d'une boucle à verrouillage de phase générant directement le signal $s_t(t)$ à la fréquence $f_t$. Par exemple, le dispositif magnétorésistif permet de diviser la fréquence $f_0$ issue de la boucle à verrouillage de phase pour la ramener à la fréquence $f_t$. Or, un premier étage de synthèse, comportant un oscillateur contrôlé en tension asservi dans une boucle à verrouillage de phase, qui fonctionne à une fréquence $f_0$ plus élevée que la fréquence $f_t$ présente un encombrement plus réduit. En effet, des éléments constitutifs du première étage de synthèse, tels qu'une inductance, sont d'autant moins volumineux que la fréquence $f_0$ est élevée. Dès lors, l'encombrement d'un premier étage de synthèse fonctionnant à une fréquence $f_0$ strictement supérieure à la fréquence $f_t$ et d'un dispositif magnétorésistif est inférieur à l'encombrement d'un oscillateur contrôlé en tension asservi dans une boucle à verrouillage de phase fonctionnant à la fréquence $f_t$.

De plus, la présence de l'oscillateur radiofréquence permet d'améliorer l'agilité spectrale du synthétiseur. En effet, en jouant sur des réglages de l'oscillateur radiofréquence, il est possible de modifier le coefficient $\alpha$ et donc de faire varier sur une large plage de fréquences la fréquence $f_t$.

Les modes de réalisation de ce synthétiseur peuvent comporter une ou plusieurs des caractéristiques des revendications dépendantes.

Ces modes de réalisation du synthétiseur présentent en outre les avantages suivants :

- l'utilisation d'un premier étage générant le signal $s_0(t)$ à une fréquence $f_0$ strictement supérieure à la fréquence $f_t$ permet de réduire l'encombrement du synthétiseur ;

- la présence d'une électronique de commande apte à modifier le réglage de l'oscillateur radiofréquence permet d'augmenter l'agilité spectrale du synthétiseur ;
- la présence d'une électronique de commande permettant de raccorder en alternance un oscillateur radiofréquence préréglé particulier à la borne de restitution permet d'augmenter l'agilité spectrale du synthétiseur ;
- l'utilisation d'un générateur de champ magnétique apte à modifier la direction du champ magnétique continu en réponse à une commande permet également d'augmenter l'agilité spectrale du synthétiseur.

L'invention a également pour objet un procédé de synthèse d'un signal $s_t(t)$ oscillant à une fréquence $f_t$ conforme à la revendication 7.

Les modes de réalisation de ce procédé peuvent comporter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :

- la figure 1 est une illustration schématique d'un synthétiseur d'un signal oscillant $s_t(t)$ à une fréquence $f_t$;
- la figure 2 est une illustration schématique d'un premier étage de synthèse d'une fréquence $f_0$ du synthétiseur de la figure 1 ;
- la figure 3 est une illustration schématique d'un deuxième étage de synthèse de la fréquence $f_t$ du synthétiseur de la figure 1 ;
- les figures 4 et 5 sont des graphes illustrant des performances d'un dispositif magnétorésistif utilisé pour la réalisation du deuxième étage de la figure 3 ;
- la figure 6 est un organigramme d'un procédé de fonctionnement du synthétiseur de la figure 1 ;
- la figure 7 est une illustration schématique d'un autre mode de réalisation du deuxième étage de la figure 3, et
- la figure 8 est une illustration schématique d'un autre mode de réalisation d'un synthétiseur du signal oscillant $s(t)$.

Dans ces figures, les mêmes références sont utilisées pour désigner les mêmes éléments.

Dans la suite de cette description, les caractéristiques et fonctions bien connues de l'homme du métier ne sont pas décrites en détail.

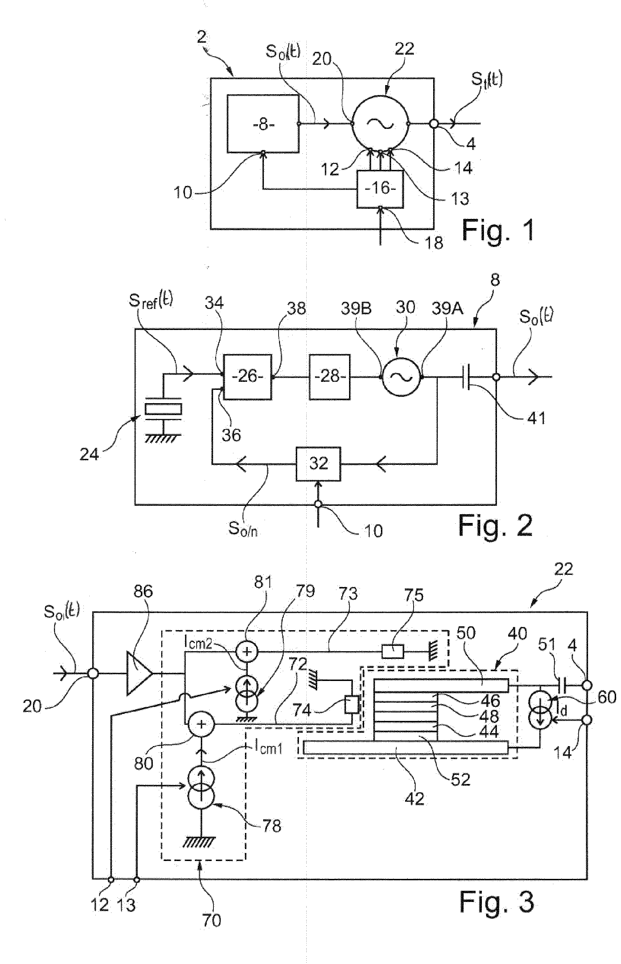

La figure 1 représente un synthétiseur 2 de fréquence. Plus précisément, le synthétiseur 2 génère un signal $s_t(t)$ oscillant à une fréquence $f_t$. Typiquement, le signal $s_t(t)$ est un signal radiofréquence dont la fréquence $f_t$ et comprise entre 100 MHz et 60 ou 120 GHz. De préférence, la fréquence $f_t$ est comprise entre 700 MHz et 40 GHz.

Le synthétiseur 2 restitue le signal $s_t(t)$ sur une borne 4. Il comprend :

- un premier étage 8 de synthèse d'un signal $s_0(t)$ oscillant à une fréquence $f_0$, et
- un deuxième étage 22 de synthèse du signal $s_t(t)$ à partir du signal $s_0(t)$.

Typiquement, le signal $s_0(t)$ présente un bon bruit de phase. Par bruit de phase, on désigne ici le rapport à la puissance de la porteuse de la puissance de bruit contenue dans une bande de 1 Hz à une distance $f_f$ de la porteuse. Le bruit de phase est exprimé en dBc/Hz par :

$$L_\varphi(f_f) = 10.\log(S_\varphi(f_f)/2)$$

où :

- $S_\varphi(f_f)$ est la densité spectrale du bruit de phase.

Par bon bruit de phase, on désigne un bruit de phase $L_\varphi$ inférieur ou égal à -50 dBc/Hz à 10 kHz de la porteuse et à -90 dBc/Hz à 10 MHz et, de préférence, inférieur ou égal à -70 dBc/Hz à 10 kHz de la porteuse et à -110 dBc/Hz à 10 MHz.

Ici, ce premier étage 8 comporte une borne 10 de réglage de la fréquence $f_0$ du signal $s_0(t)$.

Le deuxième étage 22 est réalisé à l'aide d'un oscillateur radiofréquence qui porte la même référence numérique. Cet oscillateur radiofréquence génère le signal $s_t(t)$ en phase avec le signal $s_0(t)$ lorsqu'il est synchronisé sur ce signal $s_0(t)$. Dans ces conditions, la fréquence $f_t$ est donnée par la relation suivante : $f_t = \alpha f_0$, où le coefficient a est un nombre rationnel.

Ici, l'oscillateur 22 est réglable par l'intermédiaire de trois bornes de réglage 12 à 14. Ces bornes de réglage permettent notamment de modifier la valeur du coefficient a.

Enfin, le synthétiseur 2 comporte également une électronique 16 de commande. Cette électronique 16 est raccordée aux bornes de réglage 10 et 12 à 14 de manière à faire varier la fréquence $f_t$ du signal $s_t(t)$ en fonction d'instructions reçues sur une borne de commande 18.

La figure 2 représente un mode de réalisation particulier du premier étage 8. Dans ce mode de réalisation, le premier étage 8 est un étage de synthèse comportant un oscillateur contrôlé en tension asservi dans une boucle à verrouillage de phase. Les boucles à verrouillage de phase sont bien connues. Ainsi, seuls les principaux éléments de l'étage 8 sont représentés sur la figure 2.

L'étage 8 comprend :

- une horloge de référence 24,
- un comparateur de phases 26,
- un filtre passe bas 28,
- un oscillateur commandé en tension 30, et
- un diviseur de fréquence 32.

L'horloge 24 génère un signal oscillant de référence $s_{ref}(t)$ à une fréquence $f_{ref}$. Typiquement, la fréquence $f_{ref}$ est inférieure à 100 MHz. Ici, cette fréquence $f_{ref}$ est également supérieure à 1 MHz. Par exemple, la fréquence $f_{ref}$ est égale à 10 MHz ou 27 MHz.

Le bruit de phase de l'horloge 24 est excellent c'est-à-dire qu'il est inférieur ou égal à -120 dBc/Hz à 10 kHz de la porteuse et, de préférence, inférieur ou égal à -150 dBc/Hz à 10 kHz de la porteuse.

Par exemple ici, l'horloge de référence 24 est réalisée à l'aide d'un quartz.

Le comparateur 26 est équipé de deux entrées 34 et 36. L'entrée 34 est raccordée à l'horloge 24 pour recevoir le signal $s_{ref}(t)$. Ce comparateur 26 produit sur une sortie 38 une tension fonction de l'écart entre les phases des signaux reçus sur ses entrées 34 et 36.

Le filtre 28 filtre la tension produite sur la sortie 38.

L'oscillateur 30 est plus connu sous l'acronyme VCO (Voltage Controlled Oscillator). L'oscillateur 30 génère sur une sortie 39A le signal $s_0(t)$. La fréquence du signal $s_0(t)$ est proportionnelle à la tension reçue sur une entrée 39B de cet oscillateur 30. Ici, la fréquence $f_0$ est égale à $nf_{ref}$, où n est un entier naturel.

L'entrée 39B est raccordée à la sortie du filtre 28 pour recevoir la tension filtrée. La sortie 39A est raccordée à une borne de synchronisation 20 (figure 1) de l'oscillateur 22 par l'intermédiaire d'un condensateur 41. Le condensateur 41 élimine toute composante continue du signal $s_0(t)$.

La sortie 39A est également raccordée à l'entrée 36 du comparateur de phase 26 par l'intermédiaire d'une boucle de rétroaction connue sous le terme de « boucle à verrouillage de phase ». Cette boucle de rétroaction comporte le diviseur 32 de fréquence. Le diviseur 32 est capable de diviser la fréquence du signal $s_0(t)$ par un facteur n pour produire un signal $s_{0/n}(t)$ injecté sur l'entrée 36. La fréquence du signal $s_{0/n}(t)$ est égale à la fréquence $f_0/n$.

Dans ce mode de réalisation, le facteur n est réglable par l'intermédiaire de la borne 10 de réglage. Ceci permet de modifier la fréquence $f_0$ par pas de fréquence $f_{ref}$.

La figure 3 représente plus en détail un exemple de réalisation de l'oscillateur 22. Cet oscillateur 22 est issu de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F., Etienne, P., Creuzet, G., Friederch, A. and Chazelas, J., " Giant magnetoresistance of (001) Fe/(001)Cr magnetic superlattices ", Phys.Rev.Lett., 61 (1988) 2472), ou la magnétorésistance tunnel (Moodera, JS., Kinder, LR., Wong, TM. and Meservey,R.. "Large magnetoresistance at room temperature in ferromagnetic thin film tunnel junctions", Phys.Rev.Lett 74 , (1995) 3273-6).

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversal and Spin-Wave Excitations in Co /Cu /Co Pillars", Phys.Rev.Lett. 84, 3149 (2000)).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques. Les demandes de brevet US 5 695 864 et EP1 860 769 décrivent divers développements mettant en oeuvre le principe physique mentionné précédemment. Ils décrivent notamment la précession de l'aimantation d'une couche magnétique traversée par un courant électrique polarisé en spin. Les principes physiques mis en oeuvre ainsi que la terminologie utilisée sont également décrits et définis dans la demande de brevet FR2 892 871.

La fréquence d'oscillation de ces oscillateurs radiofréquences est ajustée en jouant sur l'intensité du courant qui les traverse et, éventuellement en plus, sur un champ magnétique externe.

Ces oscillateurs radiofréquences étant connus, seuls les éléments nécessaires à la compréhension du fonctionnement du synthétiseur 2 sont décrits plus en détail.

L'oscillateur 22 comprend un dispositif magnétorésistif 40. Ce dispositif 40 est formé d'un empilement de couches magnétiques et non magnétiques. Cet empilement peut former :

- une jonction tunnel également connue sous l'acronyme anglais de TMR (Tunnel Magnetoresistance), ou
- une vanne de spin également connue sous l'acronyme anglais de GMR (Giant Magnetoresistance).

Ici, le dispositif 40 est décrit dans le cas particulier où l'empilement forme une jonction tunnel. A cet effet, l'empilement comporte au moins les couches suivantes :

- une électrode d'entrée 42 sur laquelle est injecté un courant électrique continu $I_d$,
- une couche magnétique 44, dite « couche de référence », apte à polariser en spin le courant électrique injecté sur l'électrode 42 et dont l'aimantation est de direction fixe,
- une couche magnétique 46, dite « couche libre », dont l'aimantation peut osciller lorsqu'elle est traversée par le courant polarisé en spin,
- une couche 48 non magnétique, dite « espaceur » ou « spacer » en anglais, interposée entre les deux couches précédentes pour créer la jonction tunnel, et
- une électrode de sortie 50 sur laquelle est produit le signal oscillant $s_t(t)$.

Pour obtenir une densité de courant élevée, la section transversale d'au moins l'une des couches de l'empilement présente typiquement un diamètre inférieur à 300nm et, de préférence, inférieur à 200 ou 100nm. Lorsque la section transversale n'est pas un disque, le terme « diamètre » doit être compris comme signifiant « diamètre hydraulique ». Typiquement, par densité de courant « élevée » on désigne une densité de courant supérieure à $10^6$A/cm$^2$ ou $10^7$A/cm$^2$.

Ce dispositif magnétorésistif 40 est conformé selon une géométrie connue sous l'acronyme CPP (« current perpendicular to plane »). Plus précisément, sur la figure 3, le dispositif magnétorésistif adopte une structure connue sous le terme de « nanopilier ». Dans cette structure les couches entres les électrodes 42 et 50 ont la même section horizontale.

La largeur L des différentes couches qui composent le pilier est constante. Ici, la largeur L est, typiquement, comprise entre 20 nm et 200 nm.

Les électrodes 42 et 50 permettent d'amener le courant qui traverse les différentes couches formant le dispositif magnétorésistif perpendiculairement au plan de ces couches. L'électrode 50 est raccordée électriquement à la borne 4 du synthétiseur 2 par l'intermédiaire d'un condensateur 51.

Les couches 44, 46 et 48 sont agencées et conformées de manière à permettre l'apparition des propriétés magnétoresistives, c'est-à-dire une variation de la résistance du pilier en fonction des directions d'aimantation des couches 44 et 46.

Pour améliorer la lisibilité de la figure 3, les proportions entre l'épaisseur des différentes couches n'a pas été préservée.

La couche de référence 44 est réalisée dans un matériau magnétique électriquement conducteur. Sa face supérieure est directement en contact avec l'espaceur 48. Elle présente une direction de plus facile aimantation comprise dans le plan de la couche.

La couche de référence 44 a pour fonction de polariser en spin les électrons du courant qui la traverse. Elle présente donc une épaisseur suffisante pour réaliser cette fonction.

Par exemple, la couche de référence 44 est réalisée en cobalt (Co), Nickel (Ni), Fer(Fe) ou leur alliage (CoFe, NiFe, CoFeB ...etc.). L'épaisseur de la couche de référence 44 est de l'ordre de quelques nanomètres. La couche de référence 44 peut être laminée par insertion de quelques (typiquement de 2 à 4) très fines couches de cuivre, d'argent ou d'or d'épaisseur de l'ordre de 0,2 à 0,5 nm pour réduire la longueur de diffusion de spin.

Ici, la couche de référence 44 présente une aimantation dont la direction est fixe. Par aimantation de direction fixe, on désigne le fait que la direction du moment magnétique de la couche de référence 44 est plus difficile à modifier que la direction du moment magnétique de la couche libre 46. Pour obtenir cela, ici, l'aimantation de la couche de référence 44 est piégée par une couche antiferromagnétique conductrice 52 interposée entre la couche de référence 44 et l'électrode 42. La face supérieure de la couche 52 est directement en contact avec la face inférieure de la couche de référence 44.

Typiquement, l'épaisseur de la couche 52 est comprise entre 5 et 50 nm. Elle peut être réalisée dans un alliage de manganèse tel que l'un des alliages suivants IrMn, PtMn, FeMn, ... etc. Par exemple, cette couche 52 est réalisée dans un matériau choisi dans le groupe comprenant IrMn, FeMn, PtMn, NiMn.

L'espaceur 48 est une couche non magnétique. Cet espaceur 48 est suffisamment fin pour permettre au courant polarisé en spin de passer de la couche de référence 44 à la couche libre 46 en limitant la perte de polarisation. A l'inverse, l'épaisseur de cet espaceur 48 est suffisamment grande pour assurer le découplage magnétique entre les couches 44 et 46.

L'espaceur 48 est réalisé dans un matériau isolant tel qu'un oxyde ou un nitrure d'aluminium, un oxyde de magnésium, du nitrure de tantale, du titanate de strontium ($SrTiO_3$), ... etc. Le pilier présente alors des propriétés magnétorésistives tunnel ou TMR (Tunnel Magnetoresistance) et l'espaceur 48 forme une barrière tunnel. Dans ce cas, l'épaisseur de l'espaceur 48 est typiquement comprise entre 0,5 nm et 3 nm.

Ici, la barrière tunnel du dispositif 40 est fine pour présenter un facteur RA important, c'est-à-dire supérieur à 2 ou à 5 $\Omega\mu m^2$. Le facteur RA d'une barrière tunnel est le produit de la résistance de la barrière tunnel avec son aire. Ici, l'aire est la superficie de la section transversale de la barrière tunnel.

Généralement, plus le facteur RA de la barrière tunnel est élevé plus la plage de variation de la résistivité de la jonction tunnel est élevé (par exemple supérieur à 10 %) et meilleure est la sensibilité de la jonction tunnel à la précession de l'aimantation dans la couche libre. Typiquement, pour des facteurs RA de cet ordre, on peut générer facilement des oscillations et il est possible d'obtenir des TMR comprise entre 20% et 150% du RA (typiquement 80% du RA pour un RA de 1 $\Omega\mu m^2$), ce qui permet d'obtenir une bonne sensibilité de la jonction tunnel à la précession de l'aimantation dans la couche libre.

La couche libre 46 est une couche magnétique électriquement conductrice dont l'aimantation peut plus facilement tourner ou « précesser » que celle de la couche de référence 44.

De nombreux modes de réalisation de la couche libre sont possibles. Par exemple, des modes de réalisation possibles de cette couche libre sont décrits dans la demande de brevet déposée sous le numéro FR 0 957 888 et dans la demande de brevet publiée sous le numéro FR2 892 871.

La face inférieure de la couche 46 est directement en contact avec la face supérieure de l'espaceur 48. La face supérieure est quant à elle directement en contact avec l'électrode 50. Cette couche 46 est par exemple réalisée dans un matériau ferromagnétique tel que du cobalt, du nickel ou du fer ou dans un alliage de ces différents métaux (par exemple CoFe, CoFeB, NiFe, ... etc.).

En absence de courant polarisé en spin et de champ magnétique extérieur, la direction M du moment magnétique global de la couche 46 est orientée parallèlement au plan de cette couche. La direction M correspond alors à la direction de plus facile aimantation de la couche libre.

Typiquement, cet empilement de couches est réalisé sur la face supérieure d'un substrat non représenté ici.

Le dispositif 40 fonctionne comme un oscillateur à transfert de spin également connue sous l'acronyme anglais STO (Spin Transfer Oscillator) lorsque l'intensité du courant continu $I_d$ polarisé en spin dépasse un seuil $I_c$ connu sous le terme de « courant critique d'oscillation». Lorsque l'intensité du courant $I_d$ dépasse ce seuil $I_c$, l'aimantation de la couche libre du dispositif 40 précesse de façon entretenue. Le signal $s_t(t)$ oscille alors à la fréquence libre $f_{lo}$. Typiquement, le seuil $I_c$ correspond à une densité de courant supérieure à $10^7 A/cm^2$ dans la section transversale des couches de l'empilement. Dans le cas contraire, le dispositif 40 se comporte comme un résonateur, également désigné par l'acronyme STR (Spin Transfer Resonator), et le signal oscillant généré est amorti et non pas entretenu. Toutefois, même dans ce cas, pour générer le signal oscillant amorti, la densité de courant dans la section transversale des couches de l'empilement doit être élevée.

Pour générer le courant continu $I_d$, l'oscillateur 22 comporte une source commandable 60 de courant continu. Dans ce mode de réalisation, la source 60 génère un courant continu $I_d$ dont l'intensité est supérieure au seuil $I_c$.

Pour régler la fréquence libre $f_{lo}$ d'oscillation du signal $s_t(t)$ généré par le dispositif 40, ici, l'oscillateur 22 est également équipé d'un générateur 70 d'un champ magnétique continu $H_b$. Ce générateur 70 est agencé par rapport au dispositif 40 de manière à ce que les lignes du champ magnétique $H_b$ traversent la couche libre 46. Par exemple, ce générateur 70 se présente sous la forme de deux pistes conductrices 72 et 73 alimentées en courant continu, respectivement $I_{cm1}$ et $I_{cm2}$, par des sources de courant respectives 78 et 79. Chaque piste conductrice 72, 73 crée un champ magnétique continu, respectivement $H_{b1}$ et $H_{b2}$. Le champ Hb est la résultante de la superposition de ces deux champs magnétiques $H_{b1}$ et $H_{b2}$. Les pistes 72 et 73 sont alignées le long de directions différentes de manière à ce que les champs $H_{b1}$ et $H_{b2}$ ne soient pas parallèles. Ainsi, en jouant sur l'intensité des courants $I_{cm1}$ et $I_{cm2}$ il est possible de modifier la direction du champ magnétique continu $H_b$. Par exemple, ici, les pistes 72 et 73 s'étendent le long de deux directions orthogonales situées dans un plan parallèle aux couches du dispositif 40.

Chaque piste 72, 73 est placée à proximité de l'empilement des couches du dispositif 40. Par exemple, les pistes 72 et 73 sont agencées par rapport à la couche 46 de manière à ce que les lignes des champs magnétiques $H_{b1}$ et $H_{b2}$ générées soient, respectivement, parallèles et perpendiculaires à la direction M de plus facile aimantation de la couche 46. De préférence, pour limiter la consommation électrique du générateur 70, la distance la plus courte qui sépare chaque piste conductrice 72, 73 de la couche libre 46 est inférieure à 100 $\mu$m et, avantageusement, inférieure à 10$\mu$m voire à 1 $\mu$m. Sur la figure 3, la résistivité de chaque piste 72, 73 est représentée par une résistance respective 74, 75. Par exemple, la valeur des résistances 74, 75 est égale à 10 $\Omega$ et correspond à la résistance de la piste conductrice entre la sortie de la source de courant et un potentiel de référence tel que la masse.

Ce générateur 70 comporte deux sommateurs 80, 81 dont :

- une entrée est raccordée à la borne 20 de synchronisation par l'intermédiaire d'un amplificateur 86, et
- l'autre entrée est directement raccordée à la sortie, respectivement, des sources 78 et 79 de courant continu.

Les sorties des sommateurs 80, 81 sont directement raccordées, respectivement, aux pistes 72 et 73. Ceci permet de générer, en plus du champ magnétique $H_b$, un champ magnétique alternatif $H_a$ dont la fréquence est égale à celle du signal $s_0(t)$.

La fréquence d'oscillation de l'oscillateur 22 est notée $f_t$. En absence de signal sur la borne 20, cette fréquence $f_t$ est égale à la fréquence libre $f_{lo}$ d'oscillation de l'oscillateur 22. La fréquence libre est fonction du champ $H_b$ et de l'intensité du courant $I_d$. Lorsqu'un signal oscillant est reçu sur la borne 20, l'oscillateur 22 peut se synchroniser sur ce signal oscillant. Lorsque l'oscillateur 22 est synchronisé, celui-ci produit un signal oscillant $s_t(t)$ qui oscille en phase avec le signal reçu sur la borne 20. De plus, lorsqu'il est synchronisé, la fréquence $f_t$ du signal $s_t(t)$ produit sur l'électrode 50 devient égale à $\alpha f_0$, où :

- $f_0$ est la fréquence du signal reçu sur la borne 20, et
- $\alpha$ est un nombre rationnel s'écrivant sous la forme d'une fraction M/P, où M et P sont des entiers positifs non nuls.

M peut être un entier naturel plus grand que P ou plus petit. P peut être égal à un.

A ce stade, on notera que toutes les valeurs de $\alpha$ ne sont pas possibles. En réalité, seules certaines valeurs particulières de $\alpha$ sont possibles. A ce sujet, on pourra se référer à l'article suivant :
Sergei Urazhdin et Phillip Tabor, « Franctional synchronization of spin-torque nano-oscillators », Physical review letters, PRL 105, 104101, 3 septembre 2010.

Les valeurs de $\alpha$ possibles sont par exemple déterminées expérimentalement en faisant varier la fréquence libre $f_{lo}$ et en injectant sur la borne 20 un signal de fréquence constamment égale à la fréquence $f_0$. Pour modifier la fréquence libre $f_{lo}$, il est possible de modifier l'intensité du champ magnétique $H_b$ et/ou l'intensité du courant $I_d$. Cela revient donc ici à modifier l'intensité du courant $I_d$ et/ou l'intensité d'un courant $I_{cm}$, où l'intensité du courant $I_{cm}$ est égale à la somme des intensités des courants $I_{cm1}$ et $I_{cm2}$. En effet, il est connu que la fréquence libre $f_{lo}$ dépend de l'intensité du champ magnétique $H_b$ qui traverse la couche libre et de l'intensité du courant continu $I_d$. Par exemple, il est possible d'estimer la fréquence libre $f_{lo}$ à l'aide de la relation suivante :

$$\omega(H_b, I_d) = \omega_o(H_b) + Np(I_d) \qquad (1),$$

où :

- $\omega(H_b, I_d)$ est la pulsation de la fréquence libre $f_{lo}$, c'est-à-dire $2\pi f_{lo}$.
- $\omega_o(H_b)$ est la pulsation de l'oscillateur 22 causée par le champ magnétique $H_b$,
- N est une constante déterminable expérimentalement, et
- $p(I_d)$ est l'amplitude des oscillations du signal $s_t(t)$ en fonction de l'intensité du courant $I_d$.

La pulsation $\omega_o(H_b)$ peut être donnée par une loi de Kittel. Par exemple, lorsque le champ magnétique $H_b$ généré par le générateur 70 est parallèle à l'axe de plus facile aimantation de la couche libre 46, alors la pulsation $\omega_o(H_b)$ est donnée par la relation suivante :

$$\omega_o(H_b) = (\gamma_o/2\pi)(H_b(H_b + 4\pi M_s))^{1/2} (2),$$

où :

- $\gamma_o$ est environ égal à 2,82 MHz/Oe,
- $\pi$ est le symbol "pi" radians, et
- $4\pi M_s$ est la magnétisation à saturation (environ 16.000 Oe pour une couche en CoFeB).

L'unité « Oe » est un Oersted (=$10^3/(4\pi)$ A/m soit environ 80 A/m).

Par exemple en faisant varier l'intensité du champ $H_b$ de 1 Oe à 5 kOe, cela fait varier la fréquence libre $f_{lo}$ de 356 MHz à 29 GHz. De préférence, on fait ici varier le champ Hb de 50 Oe à 1,2 kOe, ce qui correspond à une variation de la fréquence libre $f_{lo}$ de 2 GHz à 13 GHz. Dans le cas du générateur 70, l'intensité du champ magnétique Hb est modifiée en faisant varier l'intensité du courant $I_{cm}$.

Dans la relation (1), N est une constante en Hertz qui est propre au dispositif magnétorésistif 40. Elle est déterminable expérimentalement. Par exemple, l'évolution de la fréquence libre $f_{lo}$ en fonction de l'intensité du courant $I_d$ pour des oscillations de l'aimantation de la couche libre dans son plan, est mesurée. A partir de ces mesures, la constante N peut être calculée. Typiquement, celle-ci est de l'ordre de quelques GHz. Par exemple, ici $N/2\pi$ = 7,5 GHz.

Si les oscillations de l'aimantation de la couche libre ne sont pas comprises dans son plan, la constante $N/2\pi$ est typiquement supérieure à 20 GHz.

Plus d'explications sur les relations reliant la fréquence libre $f_{lo}$ aux différents paramètres du dispositif magnétorésistif peuvent être trouvées dans l'article suivant :
A. Slavin et V. Tiberkevich, « Nonlinear auto-oscillator theory of microwave generation by spin-polarized current » IEEE Transaction on magnetics, vol n°45, pp. 1875-1918(2009).

Lorsque l'oscillateur 22 est synchronisé, le bruit basse fréquence c'est-à-dire la puissance des oscillations de fréquences inférieures à 1 GHz et, de préférence, inférieure à 100 Hz est très petite. Par très petite, on indique ici le fait que la puissance du bruit basse fréquence est au moins dix fois et, de préférence, trente fois inférieure à la puissance du bruit basse fréquence mesurable en absence de synchronisation, c'est-à-dire lorsqu'aucun signal n'est reçu sur la borne 20.

De plus, lorsque l'oscillateur 22 est synchronisé alors le bruit de phase de l'oscillateur 22 est meilleur qu'en absence de synchronisation. Typiquement, le bruit de phase de l'oscillateur 22 est dix fois inférieur et, de préférence, cent fois inférieur lorsqu'il est synchronisé, à son bruit de phase lorsqu'aucun signal n'est reçu par l'intermédiaire de la borne 20.

Les informations ci-dessus permettent donc de déterminer plusieurs valeurs de $\alpha$ possibles. Dans la suite de la description, les valeurs de $\alpha$ sont uniquement celles pour lesquelles une synchronisation est possible. Par exemple, généralement les valeurs de $\alpha$ possibles sont supérieures ou égales à 1,2 et inférieures ou égales à 0,8. De préférence les valeurs de $\alpha$ possibles sont supérieures ou égales à 3/2 et inférieures ou égales à 2/3. Typiquement, les nombres entiers différents de 1 sont des valeurs possibles pour $\alpha$. A titre d'illustration, $\alpha$ est choisi dans le groupe composé de ½ ; ¾ ; 3/2 ; 5/2 ; 2 ; 3 ; 4 et 7/2.

Ici, les conditions de fonctionnement de l'oscillateur 22 sont réglées pour qu'il soit capable de se synchroniser sur le signal $s_0(t)$. Les conditions de fonctionnement sont définies comme étant les valeurs de l'intensité du courant $I_d$ et l'intensité et la direction du champ $H_b$.

Dans ce mode de réalisation, on souhaite que lorsque l'oscillateur 22 est synchronisé sur la fréquence $f_0$, il oscille à la fréquence $\alpha f_0$. Le coefficient a est choisi différent de un et, de préférence, strictement inférieur à un. De préférence, $\alpha$ est choisi dans le groupe composé de 1/2 et 3/4. Pour cela, le courant $I_d$ et le champ $H_b$ sont réglés pour que la fréquence libre $f_{lo}$ d'oscillation soit proche de la fréquence $\alpha f_0$. A cet effet, ici, les intensités des courants $I_d$, $I_{cm1}$ et $I_{cm2}$ sont réglées pour que la fréquence libre $f_{lo}$ soit égale à $\alpha f_0$. Le réglage se fait par exemple :

- en fixant l'intensité du courant $I_d$ juste au-dessus du seuil $I_c$, puis
- en déterminant à l'aide de la relation (2), le champ magnétique Hb qui permet d'obtenir une fréquence libre d'oscillation égale à $\alpha f_0$, et enfin
- en déterminant les intensités des courants $I_{cm1}$ et $I_{cm2}$ qui permettent d'obtenir ce champ $H_b$ dans la couche libre 46.

La répartition du courant entre les lignes 72 et 73 est choisie en fonction du coefficient $\alpha$ que l'on souhaite. En effet, la direction du champ $H_b$ modifie les coefficients $\alpha$ possibles.

La synchronisation se produit pour des oscillations sur la borne 20 à la fréquence $f_0$ mais également pour des oscillations sur la borne 20 à des fréquences proches de la fréquence $f_0$. Autrement dit, l'oscillateur 22 se synchronise sur toutes oscillations dont la fréquence appartient à une plage $[f_0 - \delta_0; f_0 + \delta_0]$. Dans le cas présent, la largeur $2\delta_0$ de cette plage doit être suffisamment grande pour permettre à l'oscillateur 22 de se synchroniser sur des oscillations de fréquence $f_0$ mais également sur des oscillations de fréquences proches $f_0 \pm kf_{ref}$, où k est un entier naturel. La largeur de cette plage croît lorsque l'amplitude du signal électrique $s_0(t)$ croît. Par conséquent, ici, l'amplificateur 86 est ajusté pour que l'écart $\delta_0$ soit suffisamment grand pour que les fréquences $f_t \pm kf_{ref}$ appartiennent à la plage $[f_0 - \delta_0; f_0 + \delta_0]$, quel que soit k appartenant à [0; 30] et, de préférence, à [0; 100]. Par exemple, l'amplitude du signal $s_0(t)$ est amplifiée

jusqu'à ce que cette amplitude corresponde à une intensité du champ magnétique alternatif $H_a$ à l'intérieur de la couche libre 46 au moins supérieur à 1 Oe et, de préférence, supérieur à 10 Oe.

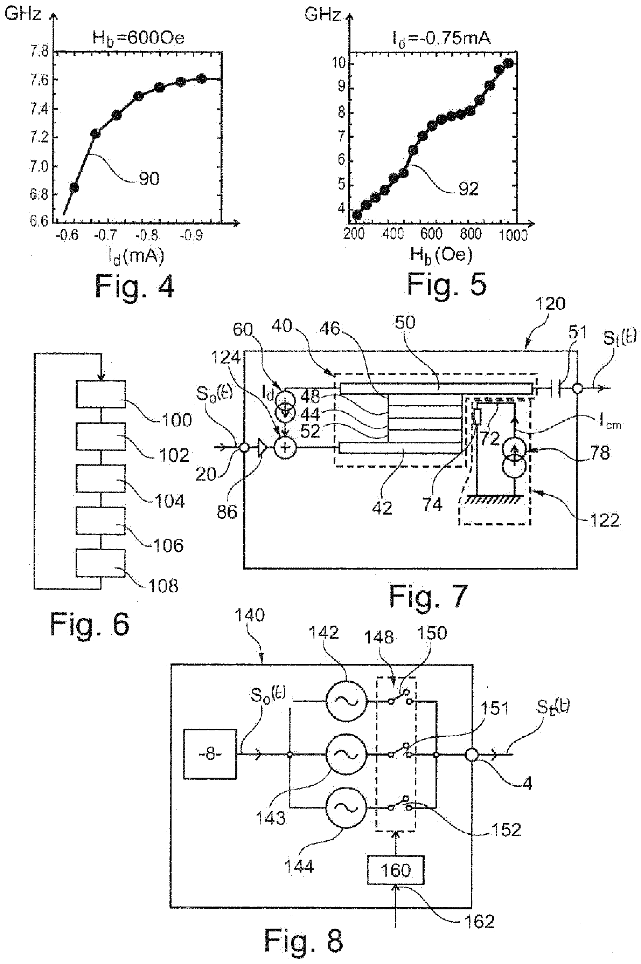

Les graphes des figures 4 et 5 illustrent les caractéristiques d'un mode particulier de réalisation du dispositif 40. La courbe 90 du graphe de la figure 4 représente l'évolution de la fréquence libre $f_{lo}$ de l'oscillateur 22 en fonction de l'intensité du courant $I_d$ lorsque le champ $H_b$ est constamment égal à 600 Oe.

La courbe 92 du graphe de la figure 5 représente l'évolution de la fréquence libre $f_{lo}$ de l'oscillateur 22 en fonction de l'intensité du champ magnétique continu $H_b$ lorsque l'intensité du courant $I_d$ est constamment égale à -0,75 mA.

Comme le montrent les graphes des figures 4 et 5, l'oscillateur 22 est ici essentiellement capable d'osciller à une fréquence $f_{lo}$ comprise entre 3 et 10 GHz.

Le fonctionnement du synthétiseur 2 va maintenant être décrit en référence au procédé de la figure 6.

Lors d'une étape 100, l'électronique 16 de commande reçoit des instructions pour régler la fréquence $f_t$.

Lors d'une étape 102, l'électronique 16 de commande règle l'étage 8 de synthèse et l'oscillateur radiofréquence 22 pour obtenir la fréquence $f_t$ correspondant aux instructions reçues sur la borne 18 de commande. Par exemple, lors de cette étape, l'électronique 16 utilise une table pré-enregistrée associant à chaque fréquence $f_t$ souhaitée des valeurs de réglage correspondantes de l'étage 8 et de l'oscillateur 22. Plus précisément, le réglage de l'étage 8 consiste à faire varier le facteur n du diviseur 32 de fréquence. Par conséquent, la fréquence $f_0$ est modifiée par pas égaux à la fréquence $f_{ref}$ de l'horloge 24. Le réglage de l'oscillateur 22 consiste à ajuster l'intensité des courants $I_d$, $I_{cm1}$ et $I_{cm2}$ pour que la fréquence libre $f_{lo}$ soit égale à $\alpha f_0$. De plus, l'intensité du courant $I_d$ est choisie supérieure ou égale à l'intensité du courant critique $I_c$ de manière à ce que le dispositif magnétorésistif 40 oscille de façon entretenue.

Lors de cette étape 102, si nécessaire, la direction du champ magnétique $H_b$ est également réglée en jouant sur la répartition du courant entre les lignes 72 et 73.

Lors d'une étape 104, l'amplificateur 86 est également réglé par l'électronique 16 de commande pour que l'écart $\delta_0$ soit suffisamment grand de manière à permettre la synchronisation de l'oscillateur 22 sur une large plage de fréquences $[f_0 - \delta_0; f_0 + \delta_0]$ autour de la fréquence $f_0$.

Ensuite, lors d'une étape 106, le premier étage 8 génère le signal $s_0(t)$ à la fréquence $f_0$. Ce signal est injecté sur la borne 20 de synchronisation de l'oscillateur 22.

Lors d'une étape 108, l'oscillateur 22 se synchronise sur le signal $s_0(t)$. Dans ces conditions, il restitue sur la borne 4 le signal $s_t(t)$ à la fréquence $\alpha f_0$ c'est-à-dire à la fréquence $f_t$.

Le procédé peut retourner à l'étape 100 pour modifier la fréquence $f_t$.

La figure 7 représente un oscillateur 120 susceptible d'être utilisé en lieu et place de l'oscillateur 22. Cet oscillateur 120 est identique à l'oscillateur 22 sauf que le générateur 70 est remplacé par un générateur 122 et le générateur 60 est raccordé à l'électrode d'entrée 42 par l'intermédiaire d'un sommateur 124.

Le générateur 122 est identique au générateur 70 sauf que les sommateurs 80, 81, la source de courant 79 et la piste 73 sont omis. Ainsi, dans ce mode de réalisation, la synchronisation avec le signal $s_0(t)$ ne se fait pas par l'intermédiaire d'un champ magnétique alternatif. Dans ce mode de réalisation, le champ magnétique $H_b$ est constant.

Le sommateur 124 possède une entrée directement raccordée à la sortie du générateur 60 de courant continu et une autre entrée raccordée à la borne 20 de synchronisation par l'intermédiaire d'un amplificateur 86. Une sortie de ce sommateur 124 est directement raccordée à l'électrode 42. Par conséquent, ce sommateur 124 ajoute le signal $s_0(t)$ au courant continu $I_d$. Ainsi, lorsque l'oscillateur 120 est utilisé à la place de l'oscillateur 22, la synchronisation de l'oscillateur sur la fréquence $f_0$ se fait en injectant le signal électrique $s_0(t)$ sur l'électrode 42.

Le fonctionnement du synthétiseur 2 lorsqu'il est équipé de l'oscillateur 120 se déduit des explications qui ont été précédemment données dans le cas de l'oscillateur 22. En particulier, pour que la synchronisation de l'oscillateur 120 sur le signal $s_0(t)$ se produise, il faut régler les intensités des courants $I_d$ et $I_{cm}$ comme décrit précédemment. Il faut également que l'amplitude du courant $s_0(t)$ ne soit pas négligeable devant l'intensité du courant $I_d$. Pour cela, l'amplificateur 86 est réglé pour que l'amplitude du courant $s_0(t)$ soit au moins supérieure à 10% de l'intensité du courant $I_d$.

La figure 8 représente un synthétiseur 140 d'un signal $s_t(t)$ oscillant à la fréquence $f_t$. Ce synthétiseur 140 est identique à celui de la figure 1 sauf que l'oscillateur radiofréquence 22 est remplacé par plusieurs oscillateurs radiofréquences raccordés en parallèle entre la borne de sortie du premier étage 8 de synthèse du signal $s_0(t)$ et la borne 4 de restitution.

Pour simplifier la figure, seuls trois oscillateurs radiofréquences 142 à 144 sont représentés.

Ici, chaque oscillateur radiofréquence 142 à 144 est réglé pour se synchroniser avec le signal $s_0(t)$. Chacun des oscillateurs 142 à 144 est également configuré pour osciller à une fréquence $f_t$ différente de celles des autres lorsqu'il est synchronisé sur le signal $s_0(t)$. Cette configuration peut être réalisée en réglant différemment les intensités des courants $I_d$, $I_{cm1}$ et $I_{cm2}$. Cette différence de configuration peut aussi être obtenue en utilisant différents dispositifs magnétorésistifs pour chaque oscillateur radiofréquence 142 à 144.

Dans ce mode de réalisation, la configuration de chaque oscillateur radiofréquence est fixée une fois pour toutes lors de la fabrication. Ainsi, les bornes de réglage de ces oscillateurs sont omises.

Le synthétiseur 140 comprend également un jeu 148 d'interrupteurs commandables. Ce jeu 148 comprend ici trois interrupteurs 150 à 152. Les interrupteurs 150 à 152 sont raccordés entre la borne 4 de restitution et, respectivement, les électrodes de sortie des oscillateurs 142 à 144.

Chaque interrupteur 150 à 152 bascule entre :

- une position fermée dans laquelle il raccorde électriquement l'électrode de sortie de l'oscillateur à la borne 4, et
- une position ouverte dans laquelle il isole électriquement l'électrode de sortie de la borne 4.

Dans ce mode de réalisation, la borne de réglage du premier étage de synthèse 8 a été omise. Dans ces conditions, l'étage 8 génère toujours un signal $s_0(t)$ à la même fréquence $f_0$.

L'électronique de commande 16 est remplacée par une électronique de commande 160 simplifiée. En effet, cette électronique de commande 160 commande uniquement le jeu d'interrupteurs 150 à 152. Plus précisément, en fonction d'instructions reçues sur une borne de commande 162, l'électronique 160 raccorde l'électrode de sortie de l'oscillateur radiofréquence qui génère le signal $s_t(t)$ ayant la fréquence correspondant aux instructions reçues à la borne de restitution 4. Ainsi, dans ce mode de réalisation, il est possible de modifier la fréquence $f_t$ du signal $s_t(t)$ sans pour autant modifier les conditions de fonctionnement de l'un des oscillateurs radiofréquence 142 à 144.

De nombreux autres modes de réalisation sont possibles. Par exemple, la fréquence $f_0$ peut être strictement inférieure ou strictement supérieure à la fréquence $f_t$.

L'électronique de commande peut être omise s'il n'est pas nécessaire de faire varier la fréquence $f_t$. Dans ce cas, le synthétiseur de fréquence est configuré une fois pour toutes lors de sa fabrication pour générer le signal $s_t(t)$ à la fréquence $f_t$. Dans ces conditions, de préférence, le coefficient $\alpha$ est strictement inférieur à un ou à 0,8.

La ligne 73 et la source 79 de courant continu du générateur 70 peuvent être omises. Dans ce cas, il n'est plus possible d'ajuster la direction du champ continu $H_b$.

Il n'est pas nécessaire que la fréquence $f_0$ soit réglable. Dans ce cas, la borne 10 de réglage peut être omise.

Le générateur du champ magnétique $H_b$ peut être distinct de celui qui génère le champ $H_a$.

Il n'est pas nécessaire que la fréquence libre $f_{lo}$ soit strictement égale à $f_t$. En variante, les intensités des courants $I_d$ et $I_{cm}$ ou $I_{cm1}$ et $I_{cm2}$ sont réglées de manière à ce que la fréquence $f_{lo}$ soit égale à la fréquence $f_t$ à plus ou moins 60 % près et de préférence à plus ou moins 45 ou 30 ou 10% près.

Dans le mode de réalisation de la figure 8, la borne de synchronisation des oscillateurs radiofréquences 142 à 144 peut être raccordée uniquement lorsque cela est utile à la sortie du premier étage 8.

De nombreux autres modes de réalisation du dispositif magnétorésistif 40 sont possibles. Par exemple, la direction de plus facile aimantation de la couche libre et/ou de la couche de référence n'est pas forcément contenue dans le plan de la couche. Par exemple, la direction de plus facile aimantation peut être perpendiculaire au plan de la couche.

Il est possible également que la couche 44 soit un multicouche, par exemple, un SyF (Synthetic Ferrimagnetic) voire un SAF (Synthetic AntiFerromagnetic). Cela permet de piéger la direction d'aimantation de la cette couche sans qu'il soit nécessaire d'utiliser une couche antiferromagnétique complémentaire pour cela. La couche 52 peut donc être omise dans ce cas.

L'espaceur 48 peut être réalisé dans un matériau électriquement conducteur tel que le cuivre (Cu). Les propriétés magnétorésistives du pilier sont alors qualifiées de magnétorésistance géante ou GMR (Giant Magnéto Resistance).

Un (ou plusieurs) polariseur peut aussi être utilisé pour réaliser le dispositif magnétorésistif en plus de la couche de référence. Un polariseur est une couche ou un multicouche magnétique dont l'aimantation est en dehors du plan de la couche et, par exemple, perpendiculaire au plan de la couche. Le polariseur permet de polariser en spin le courant qui le traverse. Typiquement, le polariseur est composé de plusieurs sous-couches superposées les unes sur les autres, par exemple une alternance de couches magnétiques et métalliques (par exemple $(Co/Pt)_n$). Ici, le polariseur n'est pas décrit plus en détail. Pour plus d'informations sur les polariseurs, il est possible de se référer à la demande de brevet FR2 817 998. La présence du polariseur permet d'obtenir une précession de l'aimantation de la couche libre en dehors de son plan. Cela permet par exemple de faire fonctionner l'oscillateur en champ nul, c'est-à-dire en absence de champ magnétique extérieur statique. Par exemple, un polariseur est directement déposé sur l'électrode 42. Ainsi, dans le mode de réalisation de la figure 8, le générateur 122 de champ magnétique peut être omis, par exemple, si un polariseur est utilisé.

Le générateur 70 de champ magnétique peut être réalisé différemment. Par exemple, le champ magnétique $H_b$ peut être généré par une couche aimantée située à proximité de la couche libre.

Le champ magnétique $H_b$ peut être parallèle ou perpendiculaire à la direction de plus facile aimantation de la couche libre. Il peut aussi former un angle quelconque avec cette direction de plus facile aimantation. Le choix de cet angle modifie les valeurs du coefficient $\alpha$ possibles.

Les synthétiseurs décris ici peuvent être utilisés comme des modulateurs de fréquences. Dans ce cas, les instructions reçues sur la borne de commande 10 sont fonctions d'une information à transmettre.

**Revendications**

1.  Synthétiseur d'un signal oscillant $s_t(t)$ à une fréquence $f_t$, ce synthétiseur comportant :

    - un premier étage (8) de synthèse de fréquence apte à générer sur une borne de sortie un signal oscillant $s_0(t)$ à une fréquence $f_0$, ce premier étage comprenant une boucle à verrouillage de phase,
    - une borne (4) de restitution sur laquelle est restitué le signal oscillant $s_t(t)$ à la fréquence $f_t$, le synthétiseur comportant également un deuxième étage de synthèse de fréquence comportant un oscillateur radiofréquence (22 ; 142-144), cet oscillateur radiofréquence comportant :

        • un dispositif magnétorésistif (40) apte à être traversé par un courant électrique polarisé en spin pour générer le signal $s_t(t)$ oscillant à la fréquence $f_t$ sur une électrode de sortie raccordée à la borne de restitution, ce dispositif étant formé d'un empilement de couches magnétiques et non magnétiques,
        • une borne (20) de synchronisation de la fréquence du signal oscillant $s_t(t)$ sur la fréquence du signal reçu sur cette borne, cette borne étant raccordée à la borne de sortie du premier étage pour recevoir le signal $s_0(t)$, l'oscillateur radiofréquence étant dit « synchronisé sur le signal $s_0(t)$ » lorsque :

            - son bruit basse fréquence c'est-à-dire la puissance des oscillations de fréquences inférieures à 1 GHz est au moins dix fois inférieure à la puissance du bruit basse fréquence mesurable en absence de synchronisation, c'est-à-dire lorsqu'aucun signal n'est reçu sur la borne (20) de synchronisation, et
            - son bruit de phase est dix fois inférieur à son bruit de phase lorsqu'aucun signal n'est reçu par l'intermédiaire de la borne (20) de synchronisation, et

        • un premier élément choisi dans le groupe composé :

            - d'une source (60) de courant pour faire circuler un courant continu d'électrons dans lesdites couches perpendiculairement à celles-ci, la source de courant continu étant réglée de manière à ce que l'oscillateur radiofréquence oscille :

                - lorsqu'il est synchronisé sur le signal $s_0(t)$ : à une fréquence $\alpha f_0$, où $\alpha$ est un nombre rationnel positif différent de un tel que $\alpha f_0 = f_t$, et
                - en absence de signal sur la borne de synchronisation de l'oscillateur radiofréquence : à une fréquence libre $f_{lo}$ égale, à $\pm$ 60% près, à la fréquence $f_t$ de l'oscillateur radiofréquence lorsqu'il est synchronisé sur le signal $s_0(t)$, et

            - d'une source (60) de courant pour faire circuler un courant continu d'électrons dans lesdites couches perpendiculairement à celles-ci et d'un générateur (70) de champ magnétique apte à générer un champ magnétique continu dont les lignes de champ traversent la couche libre du dispositif magnétorésistif avec une intensité supérieure ou égale à 1 Oe, la source de courant continu et le générateur de champ magnétique continu étant réglés de manière à ce que l'oscillateur radiofréquence oscille :

                - lorsqu'il est synchronisé sur le signal $s_0(t)$ : à une fréquence $\alpha f_0$, où $\alpha$ est un nombre rationnel positif différent de un tel que $\alpha f_0 = f_t$, et
                - en absence de signal sur la borne de synchronisation de l'oscillateur radiofréquence : à une fréquence libre $f_{lo}$ égale, à $\pm$ 60% près, à la fréquence $f_t$ de l'oscillateur radiofréquence lorsqu'il est synchronisé sur le signal $s_0(t)$,

        • au moins un deuxième élément choisi dans le groupe composé :

            - lorsque l'oscillateur radiofréquence comporte la source de courant continu, d'un sommateur (124) possédant une entrée directement raccordée à la sortie de la source (60) de courant continu, une autre entrée raccordée à la borne (20) de synchronisation par l'intermédiaire d'un amplificateur (86), et une sortie directement raccordée à une électrode (42) d'entrée du dispositif magnétorésistif (40) pour ajouter le signal $s_0(t)$ au courant continu qui circule dans lesdites couches, et
            - lorsque l'oscillateur radiofréquence comporte le générateur de champ magnétique continu, d'un générateur d'un champ magnétique alternatif dont une entrée est raccordée à la borne (20) de synchronisation par l'intermédiaire d'un amplificateur (86), et dont une sortie est directement raccordée à une piste (72, 73) pour générer, en plus du champ magnétique continu, un champ magnétique alternatif dont la fréquence est égale à celle du signal $s_0(t)$ et dont l'intensité à l'intérieur d'une couche libre (46) du dispositif magnetorésistif est au moins supérieur à 1 Oe, et

dans lequel le synthétiseur comporte :

- une table pré-enregistrée associant à des fréquences $f_t$ souhaitées des valeurs de réglage correspondantes de l'oscillateur radiofréquence (22) pour lesquelles l'oscillateur radiofréquence oscille de manière synchronisée sur le signal $s_0(t)$ à une fréquence $\alpha f_0$, où a est un nombre rationnel positif différent de un tel que $\alpha f_0 = f_t$,
- une borne de commande (18) apte à recevoir des instructions de réglage de la fréquence $f_t$,
- une électronique (16) de commande apte, en réponse aux instructions de réglage reçues sur la borne de commande et en utilisant la table pré-enregistrée, à modifier le réglage de la source de courant continu et/ou du générateur de champ magnétique continu pour que la fréquence du signal $s_t(t)$ lorsque l'oscillateur radiofréquence est synchronisé sur le signal $s_0(t)$ de même fréquence $f_0$ passe d'une fréquence $\alpha_1 f_0$ à une fréquence $\alpha_2 f_0$, où $\alpha_1$ et $\alpha_2$ sont des nombres rationnels différents.

2. Synthétiseur d'un signal oscillant $s_t(t)$ à une fréquence $f_t$, ce synthétiseur comportant :

- un premier étage (8) de synthèse de fréquence apte à générer sur une borne de sortie un signal oscillant $s_0(t)$ à une fréquence $f_0$, ce premier étage comprenant une boucle à verrouillage de phase,
- une borne (4) de restitution sur laquelle est restitué le signal oscillant $s_t(t)$ à la fréquence $f_t$, le synthétiseur comportant également un deuxième étage de synthèse de fréquence comportant un oscillateur radiofréquence (22 ; 142-144), cet oscillateur radiofréquence comportant :

  • un dispositif magnétorésistif (40) apte à être traversé par un courant électrique polarisé en spin pour générer le signal $s_t(t)$ oscillant à la fréquence $f_t$ sur une électrode de sortie raccordée à la borne de restitution, ce dispositif étant formé d'un empilement de couches magnétiques et non magnétiques,
  • une borne (20) de synchronisation de la fréquence du signal oscillant $s_t(t)$ sur la fréquence du signal reçu sur cette borne, cette borne étant raccordée à la borne de sortie du premier étage pour recevoir le signal $s_0(t)$, l'oscillateur radiofréquence étant dit « synchronisé sur le signal $s_0(t)$ » lorsque :

    - son bruit basse fréquence c'est-à-dire la puissance des oscillations de fréquences inférieures à 1 GHz est au moins dix fois inférieure à la puissance du bruit basse fréquence mesurable en absence de synchronisation, c'est-à-dire lorsqu'aucun signal n'est reçu sur la borne (20) de synchronisation, et
    - son bruit de phase est dix fois inférieur à son bruit de phase lorsqu'aucun signal n'est reçu par l'intermédiaire de la borne (20) de synchronisation, et

  • un premier élément choisi dans le groupe composé :

    - d'une source (60) de courant pour faire circuler un courant continu d'électrons dans lesdites couches perpendiculairement à celles-ci, la source de courant continu étant réglée de manière à ce que l'oscillateur radiofréquence oscille :

      - lorsqu'il est synchronisé sur le signal $s_0(t)$ : à une fréquence $\alpha f_0$, où $\alpha$ est un nombre rationnel positif différent de un tel que $\alpha f_0 = f_t$, et
      - en absence de signal sur la borne de synchronisation de l'oscillateur radiofréquence : à une fréquence libre $f_{lo}$ égale, à $\pm$ 60% près, à la fréquence $f_t$ de l'oscillateur radiofréquence lorsqu'il est synchronisé sur le signal $s_0(t)$, et

    - d'une source (60) de courant pour faire circuler un courant continu d'électrons dans lesdites couches perpendiculairement à celles-ci et d'un générateur (70) de champ magnétique apte à générer un champ magnétique continu dont les lignes de champ traversent la couche libre du dispositif magnétorésistif avec une intensité supérieure ou égale à 1 Oe, la source de courant continu et le générateur de champ magnétique continu étant réglés de manière à ce que l'oscillateur radiofréquence oscille :

      - lorsqu'il est synchronisé sur le signal $s_0(t)$ : à une fréquence $\alpha f_0$, où $\alpha$ est un nombre rationnel positif différent de un tel que $\alpha f_0 = f_t$, et
      - en absence de signal sur la borne de synchronisation de l'oscillateur radiofréquence : à une fréquence libre $f_{lo}$ égale, à $\pm$ 60% près, à la fréquence $f_t$ de l'oscillateur radiofréquence lorsqu'il est synchronisé sur le signal $s_0(t)$,

• au moins un deuxième élément choisi dans le groupe composé :

- lorsque l'oscillateur radiofréquence comporte la source de courant continu, d'un sommateur (124) possédant une entrée directement raccordée à la sortie de la source (60) de courant continu, une autre entrée raccordée à la borne (20) de synchronisation par l'intermédiaire d'un amplificateur (86), et une sortie directement raccordée à une électrode (42) d'entrée du dispositif magnétorésitif (40) pour ajouter le signal $s_0(t)$ au courant continu qui circule dans lesdites couches, et
- lorsque l'oscillateur radiofréquence comporte le générateur de champ magnétique continu, d'un générateur d'un champ magnétique alternatif dont une entrée est raccordée à la borne (20) de synchronisation par l'intermédiaire d'un amplificateur (86), et dont une sortie est directement raccordée à une piste (72, 73) pour générer, en plus du champ magnétique continu, un champ magnétique alternatif dont la fréquence est égale à celle du signal $s_0(t)$ et dont l'intensité à l'intérieur d'une couche libre (46) du dispositif magnetorésistif est au moins supérieur à 1 Oe, et

dans lequel le deuxième étage comprend :

- plusieurs oscillateurs radiofréquences (142-144) dont les bornes de synchronisation sont raccordées à la même borne de sortie du premier étage (8) pour recevoir le même signal $s_0(t)$, chaque oscillateur radiofréquence étant configuré pour osciller à une fréquence libre $f_{lo}$, en absence de signal sur la borne de synchronisation, différente de celles des autres oscillateurs radiofréquences de manière à ce que, lorsque cet oscillateur radiofréquence est synchronisé sur le signal $s_0(t)$, le signal $s_t(t)$ qu'il produit oscille à une fréquence $\alpha f_0$ avec un coefficient $\alpha$ propre à cet oscillateur radiofréquence, et
- un jeu d'interrupteurs (150-152) commandables aptes à raccorder, en alternance, l'électrode de sortie de l'un quelconque des oscillateurs radiofréquences à la borne (4) de restitution, et
- une électronique (160) de commande apte à commander, en fonction d'instructions reçues sur une borne de commande (162), le jeu d'interrupteurs pour raccorder la borne (4) de restitution à l'électrode de sortie du ou des oscillateurs radiofréquences qui produisent un signal oscillant à la fréquence $f_t$ correspondant aux instructions reçues.

3. Synthétiseur selon la revendication 1 ou 2, dans lequel le premier étage (8) comporte une seule boucle à verrouillage de phase et le premier étage (8) est configurée pour générer le signal oscillant $s_0(t)$ à une fréquence $f_0$ strictement supérieure à la fréquence $f_t$ et, de préférence, à une fréquence $f_0 \geq 2f_t$.

4. Synthétiseur selon l'une quelconque des revendications précédentes, dans lequel l'empilement de couches du dispositif magnétorésistif (40) comprend au moins les couches suivantes :

- une électrode d'entrée (42) par laquelle est injecté un courant électrique continu,
- une première couche magnétique (44), dite « couche de référence », apte à polariser en spin le courant électrique et dont l'aimantation est de direction fixe,
- une seconde couche magnétique (46), dite « couche libre », dont l'aimantation peut osciller lorsqu'elle est traversée par le courant polarisé en spin,
- une couche non magnétique (48), dite « espaceur », interposée entre les deux couches précédentes pour former une jonction tunnel ou une vanne de spin, et
- l'électrode (50) de sortie sur laquelle est produit le signal oscillant à une fréquence d'oscillation fonction de l'intensité du courant continu ou de l'amplitude d'un champ magnétique continu dont les lignes de champ traversent la couche libre,
- la section transversale d'au moins l'une des couches de cet empilement présentant un diamètre inférieur à 300 nm.

5. Synthétiseur selon l'une quelconque des revendication précédentes, dans lequel

- le générateur est apte à modifier la direction du champ magnétique continu en fonction d'une commande, et
- le synthétiseur comporte une électronique (16) de commande apte à générer ladite commande en fonction d'une valeur de la fréquence $f_t$ souhaitée par un utilisateur.

6. Synthétiseur selon l'une quelconque des revendications précédentes, dans lequel le premier élément comporte la source (60) de courant pour faire circuler un courant continu d'électrons dans lesdites couches perpendiculairement à celles-ci et le générateur (70) de champ magnétique.

7. Procédé de synthèse d'un signal $s_t(t)$ oscillant à une fréquence $f_t$ à l'aide d'un synthétiseur conforme à l'une quelconque des revendications précédentes, ce procédé comportant :

   - la génération (106) par le premier étage de synthèse, sur la borne de sortie, d'un signal oscillant $s_0(t)$ à une fréquence $f_0$, ce premier étage comprenant la boucle à verrouillage de phase,
   - la restitution sur une borne de restitution du signal $s_t(t)$ oscillant à la fréquence $f_t$, le procédé comportant la synchronisation (108) de l'oscillateur radiofréquence sur le signal $s_0(t)$, en recevant le signal $s_0(t)$ sur la borne de synchronisation de l'oscillateur radiofréquence, et en réglant la source de courant continu et/ou le générateur de champ magnétique continu de manière à ce que l'oscillateur radiofréquence oscille :

      - lorsqu'il est synchronisé sur le signal $s_0(t)$ : à une fréquence $\alpha f_o$, où $\alpha$ est un nombre rationnel positif différent de un tel que $\alpha f_0 = f_t$, et
      - en absence de signal sur la borne de synchronisation de l'oscillateur radiofréquence : à une fréquence libre $f_{lo}$ égale, à $\pm$ 60% près, à la fréquence $f_t$ de l'oscillateur radiofréquence lorsqu'il est synchronisé sur le signal $s_0(t)$.

8. Procédé selon la revendication 7, dans lequel le courant continu et/ou le champ magnétique continu sont réglés (102) de manière à ce que la fréquence libre $f_{lo}$ d'oscillation du signal oscillant produit en absence de signal sur la borne de synchronisation de l'oscillateur radiofréquence soit égale, à $\pm$ 45% près, à la fréquence $f_t$ de l'oscillateur radiofréquence lorsqu'il est synchronisé sur le signal $s_0(t)$.

9. Procédé selon la revendication 8, dans lequel le signal électrique $s_0(t)$ est amplifié de manière à ce que son amplitude sur la borne de synchronisation soit supérieure à 10 % de l'intensité du courant continu ou corresponde à un champ magnétique alternatif dont l'intensité est supérieure à 1 Oe à l'intérieur de la couche libre lorsqu'il est transformé en champ magnétique par un générateur.

**Patentansprüche**

1. Generator eines Signals $s_t(t)$, das mit einer Frequenz $f_t$ oszilliert, wobei dieser Generator Folgendes umfasst:

   - eine erste Stufe (8) zur Erzeugung einer Frequenz, die geeignet ist, um auf einem Ausgangsanschluss ein Signal $s_0(t)$, das mit einer Frequenz $f_0$ oszilliert, zu erzeugen, wobei diese erste Stufe eine Schleife mit Phasenverriegelung umfasst,
   - einen Wiedergabeanschluss (4), auf dem das Signal $s_t(t)$, das mit der Frequenz $f_t$ oszilliert, wiedergegeben wird,

   wobei der Generator auch eine zweite Frequenzerzeugungsstufe umfasst, die einen Funkfrequenzoszillator (22; 142 bis 144) umfasst, wobei dieser Funkfrequenzoszillator Folgendes umfasst:

      • eine magnetoresistive Vorrichtung (40), die geeignet ist, von einem spin-polarisierten elektrischen Strom durchquert zu werden, um das Signal $s_t(t)$, das mit der Frequenz $f_t$ oszilliert, auf einer Ausgangselektrode zu erzeugen, die an den Wiedergabeanschluss angeschlossen ist, wobei diese Vorrichtung aus einer Stapelung magnetischer und unmagnetischer Schichten gebildet ist,
      • einen Anschluss (20) zum Synchronisieren der Frequenz des Signals $s_t(t)$, das auf der Frequenz des auf diesem Anschluss empfangenen Signals oszilliert, wobei dieser Anschluss an den Ausgangsanschluss der ersten Stufe angeschlossen ist, um das Signal $s_0(t)$ zu empfangen, wobei der Funkfrequenzoszillator "auf dem Signal $s_0(t)$ synchronisiert" genannt wird, wenn:

         - sein niederfrequentes Rauschen, das heißt die Leistung der Oszillationen mit Frequenzen, die kleiner sind als 1 GHz, mindestens zehn Mal kleiner ist als die Leistung des niederfrequenten Rauschens, die bei Fehlen von Synchronisation messbar ist, das heißt wenn kein Signal auf dem Synchronisationsanschluss (20) empfangen wird, und
         - sein Phasenrauschen zehn Mal kleiner ist als sein Phasenrauschen, wenn kein Signal über den Synchronisationsanschluss (20) empfangen wird, und

• ein erstes Element, das aus einer Gruppe ausgewählt ist, die besteht aus:

- einer Stromquelle (60), um einen Gleichstrom von Elektronen in den Schichten senkrecht zu diesen zirkulieren zu lassen, wobei die Gleichstromquelle derart reguliert ist, dass der Funkfrequenzoszillator oszilliert:
- wenn er auf dem Signal $s_0(t)$ synchronisiert ist: mit einer Frequenz $\alpha f_0$, wobei a eine positive rationale Zahl, die von eins unterschiedlich ist, derart ist, dass $\alpha f_0 = f_t$, und
- bei Fehlen eines Signals auf dem Synchronisationsanschluss der Funkfrequenzoszillator: mit einer freien Frequenz $f_{l0}$, die bis auf $\pm$ 60 % gleich der Frequenz $f_t$ des Funkfrequenzoszillators ist, wenn er auf dem Signal $s_0(t)$ synchronisiert ist, oszilliert, und
- einer Stromquelle (60), um einen Gleichstrom von Elektronen in den Schichten senkrecht zu diesen zirkulieren zu lassen, und einem Magnetfeldgenerator (70), der geeignet ist, ein Gleichstrom-Magnetfeld zu erzeugen, dessen Feldlinien die freie Schicht der magnetoresistiven Vorrichtung mit einer Stärke größer oder gleich 1 Oe durchqueren, wobei die Gleichstromquelle und der Gleichstrom-Magnetfeldgenerator derart reguliert sind, dass der Funkfrequenzoszillator oszilliert:
- wenn er auf dem Signal $s_0(t)$ synchronisiert ist: mit einer Frequenz $\alpha f_0$, wobei a eine positive rationale Zahl, die von eins unterschiedlich ist, derart ist, dass $\alpha f_0 = f_t$, und
- bei Fehlen eines Signals auf dem Synchronisationsanschluss der Funkfrequenzoszillator: mit einer freien Frequenz $f_{l0}$, die bis auf $\pm$ 60 % gleich der Frequenz $f_t$ des Funkfrequenzoszillators ist, wenn er auf dem Signal $s_0(t)$ synchronisiert ist, oszilliert,

• mindestens ein zweites Element, das aus einer Gruppe ausgewählt ist, die besteht aus:

- wenn der Funkfrequenzoszillator die Gleichstromquelle umfasst, einem Summierer (124), der einen Eingang besitzt, der direkt an den Ausgang der Gleichstromquelle (60) angeschlossen ist, einen anderen Eingang, der an den Synchronisationsanschluss (20) mittels eines Verstärkers (86) angeschlossen ist, und einen Ausgang, der direkt an eine Eingangselektrode (42) der magnetoresistiven Vorrichtung (40) angeschlossen ist, um das Signal $s_0(t)$ zu dem Gleichstrom, der in den Schichten zirkuliert, hinzuzufügen, und
- wenn der Funkfrequenzoszillator den Gleichstrom-Magnetfeldgenerator umfasst, einem Generator eines Wechselstrom-Magnetfelds, von dem ein Eingang an den Synchronisationsanschluss (20) mittels eines Verstärkers (86) angeschlossen ist, und von dem ein Ausgang direkt an eine Leiterbahn (72, 73) angeschlossen ist, um zusätzlich zu dem Gleichstrom-Magnetfeld ein Wechselstrom-Magnetfeld zu erzeugen, dessen Frequenz gleich der des Signals $s_0(t)$ ist, und dessen Stärke in dem Inneren einer freien Schicht (46) der magnetoresistiven Vorrichtung mindestens größer ist als 1 Oe, und wobei der Generator Folgendes umfasst:
- eine vorab gespeicherte Tabelle, die mit gewünschten Frequenzen $f_t$ entsprechende Einstellwerte des Funkfrequenzgenerators (22) assoziiert, für die der Funkfrequenzgenerator auf dem Signal $s_0(t)$ mit einer Frequenz $\alpha f_0$ synchronisiert oszilliert, wobei a eine positive rationale Zahl ist, die von eins derart unterschiedlich ist, dass $\alpha f_0 = f_t$.
- einen Steueranschluss (18), der geeignet ist, Einstellungsanweisungen der Frequenz $f_t$ zu empfangen,
- eine Steuerelektronik (16), die geeignet ist, als Reaktion auf Einstellanweisungen, die auf dem Steueranschluss empfangen werden und unter Verwenden der vorab aufgezeichneten Tabelle die Einstellung der Gleichstromquelle und/oder des Gleichstrom-Magnetfeldgenerators zu ändern, damit Frequenz des Signals $s_t(t)$, wenn der Funkfrequenzoszillator auf dem Signal $s_0(t)$ mit gleicher Frequenz $f_0$ synchronisiert ist, von einer Frequenz $\alpha_1 f_0$ auf eine Frequenz $\alpha_2 f_0$ übergeht, wobei $\alpha_1$ und $\alpha_2$ unterschiedliche rationale Zahlen sind.

**2.** Generator eines Signals $s_t(t)$, das mit einer Frequenz $f_t$ oszilliert, wobei dieser Generator Folgendes umfasst:

- eine erste Stufe (8) zur Frequenzerzeugung, die geeignet ist, um auf einem Ausgangsanschluss ein Signal $s_0(t)$, das mit einer Frequenz $f_0$ oszilliert, zu erzeugen, wobei diese erste Stufe eine Schleife mit Phasenverriegelung umfasst,
- einen Wiedergabeanschluss (4), auf dem das Signal $s_t(t)$, das mit der Frequenz $f_t$ oszilliert, wiedergegeben wird,

wobei der Generator auch eine zweite Frequenzerzeugungsstufe umfasst, die einen Funkfrequenzoszillator (22; 142 bis 144) umfasst, wobei dieser Funkfrequenzoszillator Folgendes umfasst:

• eine magnetoresistive Vorrichtung (40), die geeignet ist, von einem spin-polarisierten elektrischen Strom durchquert zu werden, um das Signal $s_t(t)$, das mit der Frequenz $f_t$ oszilliert, auf einer Ausgangselektrode zu erzeugen, die an den Wiedergabeanschluss angeschlossen ist, wobei diese Vorrichtung aus einer Stapelung magnetischer und unmagnetischer Schichten gebildet ist,

• einen Anschluss (20) zum Synchronisieren der Frequenz des Signals $s_t(t)$, das auf der Frequenz des auf diesem Anschluss empfangenen Signal oszilliert, wobei dieser Anschluss an den Ausgangsanschluss der ersten Stufe angeschlossen ist, um das Signal $s_0(t)$ zu empfangen, wobei der Funkfrequenzoszillator "auf dem Signal $s_0(t)$ synchronisiert" genannt wird, wenn:

- sein niederfrequentes Rauschen, das heißt die Leistung der Oszillationen mit Frequenzen, die kleiner sind als 1 GHz, mindestens zehn Mal kleiner ist als die Leistung des niederfrequenten Rauschens, die bei Fehlen von Synchronisation messbar ist, das heißt wenn kein Signal auf dem Synchronisationsanschluss (20) empfangen wird, und
- sein Phasenrauschen zehn Mal kleiner ist als sein Phasenrauschen, wenn kein Signal über den Synchronisationsanschluss (20) empfangen wird, und

• ein erstes Element, das aus einer Gruppe ausgewählt ist, die besteht aus:

- einer Stromquelle (60), um einen Gleichstrom von Elektronen in den Schichten senkrecht zu diesen zirkulieren zu lassen, wobei die Gleichstromquelle derart reguliert ist, dass der Funkfrequenzoszillator oszilliert:
- wenn er auf dem Signal $s_0(t)$ synchronisiert ist: mit einer Frequenz $\alpha f_0$, wobei a eine positive rationale Zahl, die von eins unterschiedlich ist, derart ist, dass $\alpha f_0 = f_t$, und
- bei Fehlen eines Signals auf dem Synchronisationsanschluss der Funkfrequenzoszillator: mit einer freien Frequenz $f_{l0}$, die bis auf $\pm$ 60 % gleich der Frequenz $f_t$ des Funkfrequenzoszillators ist, wenn er auf dem Signal $s_0(t)$ synchronisiert ist, oszilliert, und
- einer Stromquelle (60), um einen Gleichstrom von Elektronen in den Schichten senkrecht zu diesen zirkulieren zu lassen, und einem Magnetfeldgenerator (70), der geeignet ist, ein Gleichstrom-Magnetfeld zu erzeugen, dessen Feldlinien die freie Schicht der magnetoresistiven Vorrichtung mit einer Stärke größer oder gleich 1 Oe durchqueren, wobei die Gleichstromquelle und der Gleichstrom-Magnetfeldgenerator derart reguliert sind, dass der Funkfrequenzoszillator oszilliert:
- wenn er auf dem Signal $s_0(t)$ synchronisiert ist: mit einer Frequenz $\alpha f_0$, wobei a eine positive rationale Zahl, die von eins unterschiedlich ist, derart ist, dass $\alpha f_0 = f_t$, und
- bei Fehlen eines Signals auf dem Synchronisationsanschluss der Funkfrequenzoszillator: mit einer freien Frequenz $f_{l0}$, die bis auf $\pm$ 60 % gleich der Frequenz $f_t$ des Funkfrequenzoszillators ist, wenn er auf dem Signal $s_0(t)$ synchronisiert ist, oszilliert,

• mindestens ein zweites Element, das aus einer Gruppe ausgewählt ist, die besteht aus:

- wenn der Funkfrequenzoszillator die Gleichstromquelle umfasst, einem Summierer (124), der einen Eingang besitzt, der direkt an den Ausgang der Gleichstromquelle (60) angeschlossen ist, einen anderen Eingang, der an den Synchronisationsanschluss (20) mittels eines Verstärkers (86) angeschlossen ist, und einen Ausgang, der direkt an eine Eingangselektrode (42) der magnetoresistiven Vorrichtung (40) angeschlossen ist, um das Signal $s_0(t)$ zu dem Gleichstrom, der in den Schichten zirkuliert, hinzuzufügen, und
- wenn der Funkfrequenzoszillator den Gleichstrom-Magnetfeldgenerator umfasst, einem Generator eines Wechselstrom-Magnetfelds, von dem ein Eingang an den Synchronisationsanschluss (20) mittels eines Verstärkers (86) angeschlossen ist, und von dem ein Ausgang direkt an eine Leiterbahn (72, 73) angeschlossen ist, um zusätzlich zu dem Gleichstrom-Magnetfeld ein Wechselstrom-Magnetfeld zu erzeugen, dessen Frequenz gleich der des Signals $s_0(t)$ ist, und dessen Stärke in dem Inneren einer freien Schicht (46) der magnetoresistiven Vorrichtung mindestens größer ist als 1 Oe und wobei die zweite Stufe Folgendes umfasst:
- mehrere Funkfrequenzoszillatoren (142 bis 144), deren Synchronisationsanschlüsse an denselben Ausgangsanschluss der ersten Stufe (8) angeschlossen sind, um dasselbe Signal $s_0(t)$ zu empfangen, wobei jeder Funkfrequenzoszillator konfiguriert ist, um mit einer freien Frequenz $f_{l0}$ bei Fehlen eines Signals auf dem Synchronisationsanschluss, der von denen der anderen Funkfrequenzoszillatoren unterschiedlich ist, zu oszillieren, so dass, wenn dieser Funkfrequenzoszillator auf dem Signal $s_0(t)$ synchronisiert ist, das Signal $s_t(t)$, das er erzeugt, mit einer Frequenz $\alpha f_0$ mit einem Koeffizienten a oszilliert, der diesem Funkfrequenzoszillator eigen ist, und
- einen Satz steuerbarer Schalter (150 bis 152), die geeignet sind, abwechselnd die Ausgangselektrode eines beliebigen der Funkfrequenzoszillatoren an den Wiedergabeanschluss (4) anzuschließen, und
- eine Steuerelektronik (160), die geeignet ist, um in Abhängigkeit von Anweisungen, die auf einem Steueranschluss (162) empfangen werden, den Satz von Schaltern zu steuern, um den Wiedergabeanschluss (4) an die Ausgangselektrode des oder der Funkfrequenzoszillatoren anzuschließen, die ein Signal erzeugen, das mit der Frequenz $f_t$ oszilliert, die den empfangenen Anweisungen entspricht.

3. Generator nach Anspruch 1 oder 2, wobei die erste Stufe (8) eine einzige Schleife mit Phasenverriegelung umfasst, und die erste Stufe (8) konfiguriert ist, um das Signal $s_0(t)$ zu erzeugen, das mit einer Frequenz $f_0$ oszilliert, die strikt größer ist als die Frequenz $f_t$ und, de bevorzugt mit einer Frequenz $f_0 \geq 2f_t$.

4. Generator nach einem der vorstehenden Ansprüche, wobei die Stapelung von Schichten der magnetoresistiven Vorrichtung (40) mindestens die folgenden Schichten umfasst:

   - eine Eingangselektrode (42), durch die ein Gleichstrom injiziert wird,
   - eine erste Magnetschicht (44), "Referenzschicht" genannt, die geeignet ist, den elektrischen Strom zu spinpolarisieren, und deren Magnetisierung fixe Richtung aufweist,
   - eine zweite magnetische Schicht (46), "freie Schicht" genannt, deren Magnetisierung oszillieren kann, wenn sie von dem spin-polarisierten Strom durchquert wird,
   - eine unmagnetische Schicht (48), "Abstandhalter" genannt, die zwischen den zwei vorhergehenden Schichten eingefügt ist, um einen Tunnelübergang oder ein Spinventil zu bilden, und
   - die Ausgangselektrode (50), auf der das Signal erzeugt wird, das mit einer Oszillationsfrequenz oszilliert, die von der Stärke des Gleichstroms oder der Amplitude eines Gleichstrom-Magnetfelds, dessen Feldlinien die freie Schicht durchqueren, abhängt,
   - wobei der Querschnitt mindestens einer der Schichten dieser Stapelung einen Durchmesser kleiner als 300 nm aufweist.

5. Generator nach einem der vorstehenden Ansprüche, wobei

   - der Generator geeignet ist, die Richtung des Gleichstrom-Magnetfelds in Abhängigkeit von einem Befehl zu ändern, und
   - der Generator eine Steuerelektronik (16) umfasst, die geeignet ist, um den Befehl in Abhängigkeit von einem Wert der Frequenz $f_t$, der von einem Benutzer gewünscht wird, zu erzeugen.

6. Generator nach einem der vorstehenden Ansprüche, wobei das erste Element die Stromquelle (60), um einen Gleichstrom von Elektronen in den Schichten senkrecht zu diesen zirkulieren zu lassen, und den Magnetfeldgenerator (70) umfasst.

7. Verfahren zum Erzeugen eines Signals $s_t(t)$, das mit einer Frequenz $f_t$ oszilliert, mit Hilfe eines Generators nach einem der vorstehenden Ansprüche, wobei das Verfahren Folgendes umfasst:

   - das Erzeugen (106) durch die erste Erzeugungsstufe, auf dem Ausgangsanschluss eines Signals $s_0(t)$, das mit einer Frequenz $f_0$ oszilliert, wobei diese erste Stufe eine Schleife mit Phasenverriegelung umfasst,
   - die Wiedergabe auf einem Wiedergabeanschluss des Signals $s_t(t)$, das mit der Frequenz $f_t$ oszilliert, wobei das Verfahren die Synchronisation (108) des Funkfrequenzoszillators auf dem Signal $s_0(t)$ umfasst, indem das Signal $s_0(t)$ auf dem Synchronisationsanschluss des Funkfrequenzoszillators empfangen wird, und indem die Gleichstromquelle und/oder der Gleichstrom-Magnetfeldgenerator derart reguliert werden, dass der Funkfrequenzoszillator oszilliert:
   - wenn er auf dem Signal $s_0(t)$ synchronisiert ist: mit einer Frequenz $\alpha f_0$, wobei a eine positive rationale Zahl, die von eins unterschiedlich ist, derart ist, dass $\alpha f_0 = f_t$, und
   - bei Fehlen eines Signals auf dem Synchronisationsanschluss der Funkfrequenzoszillator: mit einer freien Frequenz $f_{l0}$, die bis auf $\pm$ 60 % gleich der Frequenz $f_t$ des Funkfrequenzoszillators ist, wenn er auf dem Signal $s_0(t)$ synchronisiert ist, oszilliert.

8. Verfahren nach Anspruch 7, wobei der Gleichstrom und/oder das Gleichstrom-Magnetfeld derart reguliert sind (102), dass die freie Oszillationsfrequenz $f_{l0}$ des oszillierenden Signals bei Fehlen eines Signals auf dem Synchronisationsanschluss des Funkfrequenzoszillators, bis auf $\pm$ 45 % gleich der Frequenz $f_t$ des Funkfrequenzoszillators ist, wenn er auf dem Signal $s_0(t)$ synchronisiert ist.

**9.** Verfahren nach Anspruch 8, wobei das elektrische Signal $s_0(t)$ derart verstärkt wird, dass seine Amplitude auf dem Synchronisationsanschluss um 10 % größer ist als die Stärke des Gleichstroms, oder einem Wechselstrom-Magnetfeld entspricht, dessen Stärke größer ist als 1 Oe in dem Inneren der freien Schicht, wenn es durch einen Generator in Magnetfeld umgewandelt wird.

**Claims**

**1.** Synthesizer for a signal $s_t(t)$ oscillating at a frequency $f_t$, this synthesizer including:

- a first frequency synthesis stage (8) able to generate, on an output terminal, a signal $s_0(t)$ oscillating at a frequency $f_0$, this first stage comprising a phase-locked loop,
- a recovery terminal (4) on which the signal $s_t(t)$ oscillating at the frequency $f_t$ is recovered,

the synthesizer also including a second frequency synthesis stage including a radiofrequency oscillator (22; 142-144), this radiofrequency oscillator including:

• a magnetoresistive device (40) able to be flowed through by a spin-polarized electric current so as to generate the signal $s_t(t)$ oscillating at the frequency $f_t$ on an output electrode connected to the recovery terminal, this device being formed of a stack of magnetic and non-magnetic layers,
• a terminal (20) for synchronizing the frequency of the oscillating signal $s_t(t)$ to the frequency of the signal received on this terminal, this terminal being connected to the output terminal of the first stage so as to receive the signal $s_0(t)$, the radiofrequency oscillator being said to be "synchronized to the signal $s_0(t)$" when:

- its low-frequency noise, that is to say the power of the oscillations with frequencies lower than 1 GHz, is at least ten times lower than the power of the low-frequency noise able to be measured in the absence of synchronization, that is to say when no signal is received on the synchronization terminal (20), and
- its phase noise is ten times lower than its phase noise when no signal is received by way of the synchronization terminal (20), and

• a first element chosen from the group formed of:

- a current source (60) for channelling a direct current of electrons into said layers perpendicularly thereto, the direct current source being set such that the radiofrequency oscillator oscillates:

- when it is synchronized to the signal $s_0(t)$: at a frequency $\alpha f_0$, where $\alpha$ is a positive rational number other than one, such that $\alpha f_0 = f_t$, and
- in the absence of a signal on the synchronization terminal of the radiofrequency oscillator: at a free frequency $f_{lo}$ equal, to within $\pm 60\%$, to the frequency $f_t$ of the radiofrequency oscillator when it is synchronized to the signal $s_0(t)$, and

- a current source (60) for channelling a direct current of electrons into said layers perpendicularly thereto and a magnetic field generator (70) able to generate a steady magnetic field whose field lines pass through the free layer of the magnetoresistive device with an intensity greater than or equal to 1 Oe, the direct current source and the steady magnetic field generator being set such that the radiofrequency oscillator oscillates:

- when it is synchronized to the signal $s_0(t)$: at a frequency $\alpha f_0$, where $\alpha$ is a positive rational number other than one, such that $\alpha f_0 = f_t$, and
- in the absence of a signal on the synchronization terminal of the radiofrequency oscillator: at a free frequency $f_{lo}$ equal, to within $\pm 60\%$, to the frequency $f_t$ of the radiofrequency oscillator when it is synchronized to the signal $s_0(t)$,

• at least one second element chosen from the group formed of:

- when the radiofrequency oscillator includes the direct current source, an adder (124) having one input directly connected to the output of the direct current source (60), another input connected to the synchronization terminal (20) by way of an amplifier (86), and an output directly connected to an input electrode (42) of the magnetoresistive device (40) so as to add the signal $s_0(t)$ to the direct current flowing in said layers, and
- when the radiofrequency oscillator includes the steady magnetic field generator, an alternating magnetic field generator, one input of which is connected to the synchronization terminal (20) by way of an amplifier (86), and one output of which is directly connected to a track (72, 73) so as to generate, in addition to the steady magnetic field, an alternating magnetic field the frequency of which is equal to that of the signal $s_0(t)$ and the intensity of which inside a free layer (46) of the magnetoresistive device is at least greater than 1 Oe, and

wherein the synthesizer includes:

- a pre-recorded table associating, with desired frequencies $f_t$, corresponding setting values of the radiofrequency oscillator (22) for which the radiofrequency oscillator oscillates in a manner synchronized to the signal $s_0(t)$ at a frequency $\alpha f_0$, where $\alpha$ is a positive rational number other than one, such that $\alpha f_0 = f_t$,
- a control terminal (18) able to receive instructions for setting the frequency $f_t$,
- control electronics (16) able, in response to the setting instructions received on the control terminal and using the pre-recorded table, to modify the setting of the direct current source and/or of the steady magnetic field generator so that the frequency of the signal $s_t(t)$, when the radiofrequency oscillator is synchronized to the signal $s_0(t)$ of the same frequency $f_0$, changes from a frequency $\alpha_1 f_0$ to a frequency $\alpha_2 f_0$, where $\alpha_1$ and $\alpha_2$ are different rational numbers.

2. Synthesizer for a signal $s_t(t)$ oscillating at a frequency $f_t$, this synthesizer including:

- a first frequency synthesis stage (8) able to generate, on an output terminal, a signal $s_0(t)$ oscillating at a frequency $f_0$, this first stage comprising a phase-locked loop,
- a recovery terminal (4) on which the signal $s_t(t)$ oscillating at the frequency $f_t$ is recovered,

the synthesizer also including a second frequency synthesis stage including a radiofrequency oscillator (22; 142-144), this radiofrequency oscillator including:

• a magnetoresistive device (40) able to be flowed through by a spin-polarized electric current so as to generate the signal $s_t(t)$ oscillating at the frequency $f_t$ on an output electrode connected to the recovery terminal, this device being formed of a stack of magnetic and non-magnetic layers,
• a terminal (20) for synchronizing the frequency of the oscillating signal $s_t(t)$ to the frequency of the signal received on this terminal, this terminal being connected to the output terminal of the first stage so as to receive the signal $s_0(t)$, the radiofrequency oscillator being said to be "synchronized to the signal $s_0(t)$" when:

- its low-frequency noise, that is to say the power of the oscillations with frequencies lower than 1 GHz, is at least ten times lower than the power of the low-frequency noise able to be measured in the absence of synchronization, that is to say when no signal is received on the synchronization terminal (20), and
- its phase noise is ten times lower than its phase noise when no signal is received by way of the synchronization terminal (20), and

• a first element chosen from the group formed of:

- a current source (60) for channelling a direct current of electrons into said layers perpendicularly thereto, the direct current source being set such that the radiofrequency oscillator oscillates:
- when it is synchronized to the signal $s_0(t)$: at a frequency $\alpha f_0$, where $\alpha$ is a positive rational number other than one, such that $\alpha f_0 = f_t$, and
- in the absence of a signal on the synchronization terminal of the radiofrequency oscillator: at a free frequency $f_{lo}$ equal, to within $\pm 60\%$, to the frequency $f_t$ of the radiofrequency oscillator when it is synchronized to the signal $s_0(t)$, and
- a current source (60) for channelling a direct current of electrons into said layers perpendicularly thereto and a magnetic field generator (70) able to generate a steady magnetic field whose field lines pass through the free layer of the magnetoresistive device with an intensity greater than or equal to 1 Oe, the direct current source and the steady magnetic field generator being set such that the radiofrequency oscillator oscillates:

- when it is synchronized to the signal $s_0(t)$: at a frequency $\alpha f_0$, where $\alpha$ is a positive rational number

19

other than one, such that $\alpha f_0 = f_t$, and
- in the absence of a signal on the synchronization terminal of the radiofrequency oscillator: at a free frequency $f_{lo}$ equal, to within $\pm 60\%$, to the frequency $f_t$ of the radiofrequency oscillator when it is synchronized to the signal $s_0(t)$,

• at least one second element chosen from the group formed of:

- when the radiofrequency oscillator includes the direct current source, an adder (124) having one input directly connected to the output of the direct current source (60), another input connected to the synchronization terminal (20) by way of an amplifier (86), and an output directly connected to an input electrode (42) of the magnetoresistive device (40) so as to add the signal $s_0(t)$ to the direct current flowing in said layers, and
- when the radiofrequency oscillator includes the steady magnetic field generator, an alternating magnetic field generator, one input of which is connected to the synchronization terminal (20) by way of an amplifier (86), and one output of which is directly connected to a track (72, 73) so as to generate, in addition to the steady magnetic field, an alternating magnetic field the frequency of which is equal to that of the signal $s_0(t)$ and the intensity of which inside a free layer (46) of the magnetoresistive device is at least greater than 1 Oe, and

wherein the second stage comprises:

- a plurality of radiofrequency oscillators (142-144) whose synchronization terminals are connected to the same output terminal of the first stage (8) so as to receive the same signal $s_0(t)$, each radiofrequency oscillator being configured so as to oscillate at a free frequency $f_{lo}$, in the absence of a signal on the synchronization terminal, different from those of the other radiofrequency oscillators such that, when this radiofrequency oscillator is synchronized to the signal $s_0(t)$, the signal $s_t(t)$ that it produces oscillates at a frequency $\alpha f_0$ with a coefficient $\alpha$ specific to this radiofrequency oscillator, and
- a commandable set of switches (150-152) able to alternately connect the output electrode of any one of the radiofrequency oscillators to the recovery terminal (4), and
- control electronics (160) able to command, on the basis of instructions received on a control terminal (162), the set of switches so as to connect the recovery terminal (4) to the output electrode of the radiofrequency oscillator or oscillators that produce a signal oscillating at the frequency $f_t$ corresponding to the received instructions.

3. Synthesizer according to Claim 1 or 2, wherein the first stage (8) includes a single phase-locked loop and the first stage (8) is configured so as to generate the oscillating signal $s_0(t)$ at a frequency $f_0$ strictly higher than the frequency $f_t$ and, preferably, at a frequency $f_0 \geq 2f_t$.

4. Synthesizer according to any one of the preceding claims, wherein the stack of layers of the magnetoresistive device (40) comprises at least the following layers:

- an input electrode (42) by way of which a direct electric current is injected,
- a first magnetic layer (44), called "reference layer", able to spin-polarize the electric current and whose magnetization has a fixed direction,
- a second magnetic layer (46), called "free layer", whose magnetization may oscillate when it is flowed through by the spin-polarized current,
- a non-magnetic layer (48), called "spacer", interposed between the two preceding layers so as to form a tunnel junction or a spin valve, and
- the output electrode (50) on which the oscillating signal is produced at an oscillation frequency that depends on the intensity of the direct current or on the amplitude of a steady magnetic field whose field lines pass through the free layer,
- the cross section of at least one of the layers of this stack having a diameter smaller than 300 nm.

5. Synthesizer according to any one of the preceding claims, wherein

- the generator is able to modify the direction of the steady magnetic field on the basis of a command, and
- the synthesizer includes control electronics (16) able to generate said command on the basis of a value of the frequency $f_t$ desired by a user.

6. Synthesizer according to any one of the preceding claims, wherein the first element includes the current source (60) for channelling a direct current of electrons into said layers perpendicularly thereto and the magnetic field generator (70).

7. Method for synthesizing a signal $s_t(t)$ oscillating at a frequency $f_t$ using a synthesizer according to any one of the preceding claims, this method including:

   - generation (106), by the first synthesis stage, on the output terminal, of a signal $s_0(t)$ oscillating at a frequency $f_0$, this first stage comprising the phase-locked loop,
   - recovery, on a recovery terminal, of the signal $s_t(t)$ oscillating at the frequency $f_t$,
   the method including synchronizing (108) the radiofrequency oscillator to the signal $s_0(t)$, by receiving the signal $s_0(t)$ on the synchronization terminal of the radiofrequency oscillator, and by setting the direct current source and/or the steady magnetic field generator such that the radiofrequency oscillator oscillates:

   - when it is synchronized to the signal $s_0(t)$: at a frequency $\alpha f_0$, where $\alpha$ is a positive rational number other than one, such that $\alpha f_0 = f_t$, and
   - in the absence of a signal on the synchronization terminal of the radiofrequency oscillator: at a free frequency $f_{lo}$ equal, to within $\pm 60\%$, to the frequency $f_t$ of the radiofrequency oscillator when it is synchronized to the signal $s_0(t)$.

8. Method according to Claim 7, wherein the direct current and/or the steady magnetic field are set (102) such that the free oscillation frequency $f_{lo}$ of the oscillating signal produced in the absence of a signal on the synchronization terminal of the radiofrequency oscillator is equal, to within $\pm 45\%$, to the frequency $f_t$ of the radiofrequency oscillator when it is synchronized to the signal $s_0(t)$.

9. Method according to Claim 8, wherein the electrical signal $s_0(t)$ is amplified such that its amplitude on the synchronization terminal is greater than 10% of the intensity of the direct current or corresponds to an alternating magnetic field whose intensity is greater than 1 Oe inside the free layer when it is transformed into a magnetic field by a generator.

EP 2 515 432 B1

Fig. 1

Fig. 2

Fig. 3

22

Fig. 4

Fig. 5

Fig. 6

Fig. 7

Fig. 8

23

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011051481 A1
- US 5695864 A
- EP 1860769 A

- FR 2892871
- FR 0957888
- FR 2817998


**Littérature non-brevet citée dans la description**

- **SERGEI URAZHDIN et al.** Fractionnai Synchronization of Spin-Torque Nono-Oscillator. *Physical Review Letters,* 01 Août 2010, vol. 105 (10
- **B. GEORGES et al.** Coupling efficiency for phase locking of a spin transfer nano-Oscillatorto a microwave current. *Physical Review letters,* 01 Juillet 2008, vol. 101 (1
- **W. RIPPARD et al.** Injection locking and phase control of spin transfer Nano-oscillators. *Physical Review letters,* 01 Août 2005, vol. 95 (6
- Spintorque Oscillator Characteristics in coupled Networks. **ZARUDNIEV M et al.** Hardware and software implementation and control of distributed mems (DMEMS), 2010, First Workshop on. IEEE, 28 Juin 2010, 20-23
- **BAIBICH, M. ; BROTO, J.M. ; FERT, A. ; NGUYEN VAN DAU, F. ; PETROFF, F. ; ETIENNE, P. ; CREUZET, G. ; FRIEDERCH, A. ; CHAZELAS, J.** Giant magnetoresistance of (001) Fe/(001)Cr magnetic superlattices. *Phys.Rev.Lett.,* 1988, vol. 61, 2472

- **MOODERA, JS. ; KINDER, LR. ; WONG, TM. ; MESERVEY,R.** Large magnetoresistance at room temperature in ferromagnetic thin film tunnel junctions. *Phys.Rev.Lett,* 1995, vol. 74, 3273-6
- **KATINE, J.A. ; ALBERT, F.J. ; BUHRMAN, R.A. ; MYERS, E.B. ; RALPH, D.C.** Current-Driven Magnetization Reversal and Spin-Wave Excitations in Co /Cu /Co Pillars. *Phys.Rev.Lett.,* 2000, vol. 84, 3149
- **KISELEV, S.I. ; SANKEY, J.C. ; KRIVOROTOV, LN. ; EMLEY, N.C. ; SCHOELKOPF, R.J. ; BUHRMAN, R.A. ; RALPH, D.C.** Microwave oscillations of a nanomagnet driven by a spin-polarized current. *Nature,* 2003, vol. 425, 380
- **SERGEI URAZHDIN ; PHILLIP TABOR.** Franctional synchronization of spin-torque nano-oscillators. *Physical review letters, PRL,* 03 Septembre 2010, vol. 105, 104101
- **A. SLAVIN ; V. TIBERKEVICH.** Nonlinear auto-oscillator theory of microwave generation by spin-polarized current. *IEEE Transaction on magnetics,* 2009, 1875-1918